# EUROPEAN PATENT APPLICATION

(11) **EP 4 503 645 A1**
(43) Date of publication of application: **05.02.2025**
(21) Application number: 23780204.6
(22) Date of filing: 24.03.2023
(51) Int. Cl.: H04N 25/771, H01L 27/146, H04N 25/70

(54) **IMAGING ELEMENT, IMAGING DEVICE, AND SEMICONDUCTOR ELEMENT**

(30) Priority: 31.03.2022 JP 2022061311
(71) Applicant: Sony Semiconductor Solutions Corporation, Atsugi-shi, Kanagawa 243-0014 (JP)
(72) Inventor: FUKUI, Ryo, Atsugi-shi, Kanagawa 243-0014 (JP); TOMITA, Ken, Atsugi-shi, Kanagawa 243-0014 (JP); OKAWA, Tatsuya, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/011899
(87) International publication number: WO 2023/190194

(57) **Abstract**

A voltage to be applied to a charge holding section to which charges generated by a plurality of photoelectric conversion sections are transferred is adjusted. An imaging element (1) includes a plurality of photoelectric conversion sections (100), a charge holding section (106), a plurality of charge transfer sections (102), an image signal generation section (120), and a plurality of capacitive coupling wirings (161,162). The photoelectric conversion section (100) performs photoelectric conversion of incident light to generate a charge. The charge holding section (106) holds the generated charge. The charge transfer section (102) is arranged for each photoelectric conversion section (100) and transfers the generated charge to the charge holding section (106). The image signal generation section (120) generates an image signal corresponding to the held electric charge. The capacitive coupling wirings (161,162) are capacitively coupled to the charge holding section (106), and are individually applied with an adjustment signal for adjusting the potential of the charge holding section (106).

## Description

### Field

The present disclosure relates to an imaging element, an imaging apparatus, and a semiconductor element.

### Background

A MOS-type photoelectric conversion element configured by arranging a plurality of pixels including a photoelectric conversion section that performs photoelectric conversion of incident light is used. In this MOS-type photoelectric conversion element, the charge generated by the photoelectric conversion element during the exposure period is transferred to and held in the charge holding section. An image signal is generated and output on the basis of the held electric charge. A floating diffusion region (floating diffusion) formed in the semiconductor substrate is used for the charge holding section.

For downsizing, an imaging element has been proposed in which a charge holding section (floating diffusion) is shared by a plurality of pixels and the charge holding section is downsized (see, for example, Patent Literature 1). In this imaging element, wiring for applying a voltage to the charge holding section is provided in order to compensate for insufficiency of the capacitance of the charge holding section. When a charge is transferred from the photoelectric conversion section, a voltage is applied to the wiring to boost the charge holding section that performs capacitive coupling. As a result, the capacitance of the charge holding section can be increased.

### Citation List

### Patent Literature

Patent Literature 1: WO 2020/022054 A

### Summary

### Technical Problem

However, in the above-described conventional technique, there is a problem that the voltage applied to the charge holding section cannot be adjusted when the charge amount transferred to the charge holding section changes.

Therefore, the present disclosure proposes an imaging element, an imaging apparatus, and a semiconductor element that adjust a voltage applied to a charge holding section to which charges generated by a plurality of photoelectric conversion sections are transferred.

### Solution to Problem

An imaging element according to the present disclosure includes: a plurality of photoelectric conversion sections, a charge holding section, a plurality of charge transfer sections, an image signal generation section, and a plurality of capacitive coupling wirings. The photoelectric conversion section performs photoelectric conversion of incident light to generate a charge. The charge holding section holds the generated charge. The charge transfer section is arranged for each photoelectric conversion section and transfers the generated charge to the charge holding section. The image signal generation section generates an image signal corresponding to the held electric charge. The capacitive coupling wirings are capacitively coupled to the charge holding section, and are individually applied with an adjustment signal for adjusting the potential of the charge holding section.

### Brief Description of Drawings

FIG. 1 is a diagram illustrating a configuration example of an imaging element according to an embodiment of the present disclosure.
FIG. 2 is a diagram illustrating a configuration example of a pixel block according to a first embodiment of the present disclosure.
FIG. 3 is a diagram illustrating a configuration example of the pixel block according to the first embodiment of the present disclosure.
FIG. 4 is a cross-sectional view illustrating a configuration example of the pixel block according to the first embodiment of the present disclosure.
FIG. 5 is a diagram illustrating an example of generation of an image signal according to the first embodiment of the present disclosure.
FIG. 6A is a diagram illustrating an example of a potential of a pixel according to the first embodiment of the present disclosure.
FIG. 6B is a diagram illustrating an example of the potential of the pixel according to the first embodiment of the present disclosure.
FIG. 6C is a diagram illustrating an example of the potential of the pixel according to the first embodiment of the present disclosure.
FIG. 6D is a diagram illustrating an example of the potential of the pixel according to the first embodiment of the present disclosure.
FIG. 7A is a diagram illustrating an example of a capacitive coupling wiring according to the first embodiment of the present disclosure.
FIG. 7B is a diagram illustrating an example of the capacitive coupling wiring according to the first embodiment of the present disclosure.
FIG. 7C is a diagram illustrating an example of the capacitive coupling wiring according to the first embodiment of the present disclosure.
FIG. 7D is a diagram illustrating an example of the capacitive coupling wiring according to the first embodiment of the present disclosure.
FIG. 8 is a diagram illustrating a configuration example of a pixel block 100 according to a second embodiment of the present disclosure.
FIG. 9 is a diagram illustrating a configuration example of a pixel block 100 according to a third embodiment of the present disclosure.
FIG. 10 is a diagram illustrating an example of a capacitive coupling wiring according to the third embodiment of the present disclosure.
FIG. 11 is a diagram illustrating another configuration example of the pixel block according to the third embodiment of the present disclosure.
FIG. 12 is a diagram illustrating another configuration example of the pixel block according to the third embodiment of the present disclosure.
FIG. 13 is a diagram illustrating an arrangement example of the pixel block according to the third embodiment of the present disclosure.
FIG. 14 is a cross-sectional view illustrating a configuration example of a pixel block according to a fourth embodiment of the present disclosure.
FIG. 15A is a diagram illustrating an example of a capacitive coupling wiring according to the fourth embodiment of the present disclosure.
FIG. 15B is a diagram illustrating an example of the capacitive coupling wiring according to the fourth embodiment of the present disclosure.
FIG. 16 is a diagram illustrating another example of the capacitive coupling wiring according to the fourth embodiment of the present disclosure.
FIG. 17A is a diagram illustrating a configuration example of the capacitive coupling wiring according to the fourth embodiment of the present disclosure.
FIG. 17B is a diagram illustrating a configuration example of the capacitive coupling wiring according to the fourth embodiment of the present disclosure.
FIG. 17C is a diagram illustrating a configuration example of the capacitive coupling wiring according to the fourth embodiment of the present disclosure.
FIG. 18A is a diagram illustrating another configuration example of the capacitive coupling wiring according to the fourth embodiment of the present disclosure.
FIG. 18B is a diagram illustrating another configuration example of the capacitive coupling wiring according to the fourth embodiment of the present disclosure.
FIG. 19A is a diagram illustrating a configuration example of a capacitive coupling wiring according to a sixth embodiment of the present disclosure.
FIG. 19B is a diagram illustrating a configuration example of the capacitive coupling wiring according to the sixth embodiment of the present disclosure.
FIG. 20A is a diagram illustrating another configuration example of the capacitive coupling wiring according to the sixth embodiment of the present disclosure.
FIG. 20B is a diagram illustrating another configuration example of the capacitive coupling wiring according to the sixth embodiment of the present disclosure.
FIG. 21A is a diagram illustrating another configuration example of the capacitive coupling wiring according to the sixth embodiment of the present disclosure.
FIG. 21B is a diagram illustrating another configuration example of the capacitive coupling wiring according to the sixth embodiment of the present disclosure.
FIG. 22A is a diagram illustrating another configuration example of the capacitive coupling wiring according to the sixth embodiment of the present disclosure.
FIG. 22B is a diagram illustrating another configuration example of the capacitive coupling wiring according to the sixth embodiment of the present disclosure.
FIG. 23 is a diagram illustrating another configuration example of the capacitive coupling wiring according to the sixth embodiment of the present disclosure.
FIG. 24 is a diagram illustrating a configuration example of an imaging element according to a seventh embodiment of the present disclosure.
FIG. 25 is a cross-sectional view illustrating a configuration example of the imaging element according to the seventh embodiment of the present disclosure.
FIG. 26 is a diagram illustrating another configuration example of the imaging element according to the seventh embodiment of the present disclosure.
FIG. 27 is a diagram illustrating another configuration example of the imaging element according to the seventh embodiment of the present disclosure.
FIG. 28A is a diagram illustrating a method of manufacturing the imaging element according to the seventh embodiment of the present disclosure.
FIG. 28B is a diagram illustrating the method of manufacturing the imaging element according to the seventh embodiment of the present disclosure.
FIG. 28C is a diagram illustrating the method of manufacturing the imaging element according to the seventh embodiment of the present disclosure.
FIG. 28D is a diagram illustrating the method of manufacturing the imaging element according to the seventh embodiment of the present disclosure.
FIG. 28E is a diagram illustrating the method of manufacturing the imaging element according to the seventh embodiment of the present disclosure.
FIG. 28F is a diagram illustrating the method of manufacturing the imaging element according to the seventh embodiment of the present disclosure.
FIG. 28G is a diagram illustrating the method of manufacturing the imaging element according to the seventh embodiment of the present disclosure.
FIG. 29A is a diagram illustrating a configuration example of a semiconductor element according to an eighth embodiment of the present disclosure.
FIG. 29B is a diagram illustrating a configuration example of the semiconductor element according to the eighth embodiment of the present disclosure.
FIG. 29C is a diagram illustrating a configuration example of the semiconductor element according to the eighth embodiment of the present disclosure.
FIG. 29D is a diagram illustrating a configuration example of the semiconductor element according to the eighth embodiment of the present disclosure.
FIG. 30A is a diagram illustrating another configuration example of the semiconductor element according to the eighth embodiment of the present disclosure.
FIG. 30B is a diagram illustrating another configuration example of the semiconductor element according to the eighth embodiment of the present disclosure.
FIG. 30C is a diagram illustrating another configuration example of the semiconductor element according to the eighth embodiment of the present disclosure.
FIG. 31 is a diagram illustrating another configuration example of the semiconductor element according to the eighth embodiment of the present disclosure.
FIG. 32A is a diagram illustrating another configuration example of the semiconductor element according to the eighth embodiment of the present disclosure.
FIG. 32B is a diagram illustrating another configuration example of the semiconductor element according to the eighth embodiment of the present disclosure.
FIG. 33 is a diagram illustrating an example of a schematic configuration of an imaging system including the imaging apparatus according to the above-described embodiments and the modifications thereof.
FIG. 34 is a diagram illustrating an example of an imaging procedure of the imaging system illustrated in FIG. 33.
FIG. 35 is a block diagram depicting an example of schematic configuration of a vehicle control system.
FIG. 36 is a diagram of assistance in explaining an example of installation positions of an outside-vehicle information detecting section and an imaging section.
FIG. 37 is a view depicting an example of a schematic configuration of an endoscopic surgery system.
FIG. 38 is a block diagram depicting an example of a functional configuration of a camera head and a camera control unit (CCU).

### Description of Embodiments

Hereinafter, embodiments of the present disclosure will be described in detail with reference to the drawings. The description will be given in the following order. Note that, in each of the following embodiments, the same parts are denoted by the same reference signs, and redundant description will be omitted.
1. First Embodiment
2. Second Embodiment
3. Third Embodiment
4. Fourth Embodiment
5. Fifth Embodiment
6. Sixth Embodiment
7. Seventh Embodiment
8. Eighth Embodiment
9. Application Example
10. Applied Example to Mobile Body
11. Applied Example to Endoscopic Surgery System

### (1. First Embodiment)

### [Configuration of Imaging Element]

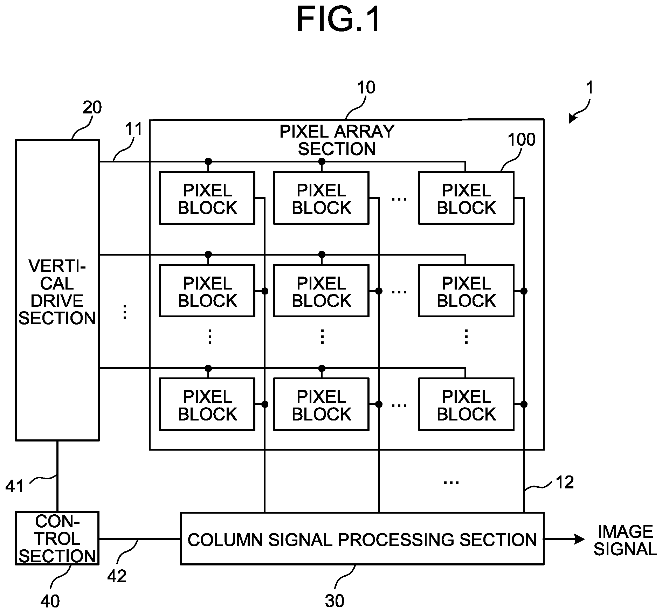

FIG. 1 is a diagram illustrating a configuration example of an imaging element according to an embodiment of the present disclosure. The drawing is a block diagram illustrating a configuration example of an imaging element 1. A semiconductor element according to an embodiment of the present disclosure will be described by taking the imaging element 1 as an example. The imaging element 1 is a semiconductor element that generates image data of a subject. The imaging element 1 includes a pixel array section 10, a vertical drive section 20, a column signal processing section 30, and a control section 40.

The pixel array section 10 is configured by arranging a plurality of pixel blocks 100. In the pixel array section 10, the plurality of pixel blocks 100 is arranged in a shape of a two-dimensional matrix. Here, the pixel block 100 includes a plurality of pixels having a photoelectric conversion section that performs photoelectric conversion of incident light, and a charge holding section (charge holding section 106 to be described later) that holds a charge generated by photoelectric conversion. For example, a photodiode can be used as the photoelectric conversion section. Furthermore, an image signal generation section (image signal generation section 120 to be described later) is arranged for each pixel block 100. The image signal generation section 120 generates an image signal on the basis of the charge held in the charge holding section 106 of the pixel block 100.

A signal line 11 is wired to each pixel block 100 and the image signal generation section 120. The pixel block 100 and the image signal generation section 120 are controlled by a control signal transmitted by the signal line 11. Furthermore, a signal line 12 is wired to the image signal generation section 120. An image signal is output from the image signal generation section 120 to the signal line 12. Note that the signal line 11 is arranged for each row of the shape of the two-dimensional matrix, and is commonly wired to the plurality of pixel blocks 100 and the image signal generation section 120 arranged in one row. The signal lines 12 are arranged in the column direction of the two-dimensional matrix, and are commonly wired to the plurality of pixel blocks 100 arranged in one column.

The vertical drive section 20 generates a control signal for the pixel block 100 described above. The vertical drive section 20 in the drawing generates a control signal for each row of the two-dimensional matrix of the pixel array section 10 and sequentially outputs the control signal via the signal line 11.

The column signal processing section 30 processes the image signal generated by the pixel block 100. The column signal processing section 30 in the drawing simultaneously processes the image signals from the plurality of pixel blocks 100 arranged in one row of the pixel array section 10 transmitted via the signal line 12. As this processing, for example, analog-digital conversion for converting an analog image signal generated by the pixel block 100 into a digital image signal and correlated double sampling (CDS) for removing an offset error of the image signal can be performed. The processed image signal is output to a circuit or the like outside the imaging element 1.

The control section 40 controls the vertical drive section 20 and the column signal processing section 30. The control section 40 in the drawing outputs control signals via signal lines 41 and 42, respectively, to control the vertical drive section 20 and the column signal processing section 30. Note that the vertical drive section 20 in the drawing is an example of a control section. The column signal processing section 30 is an example of a processing circuit.

### [Configuration of Pixel]

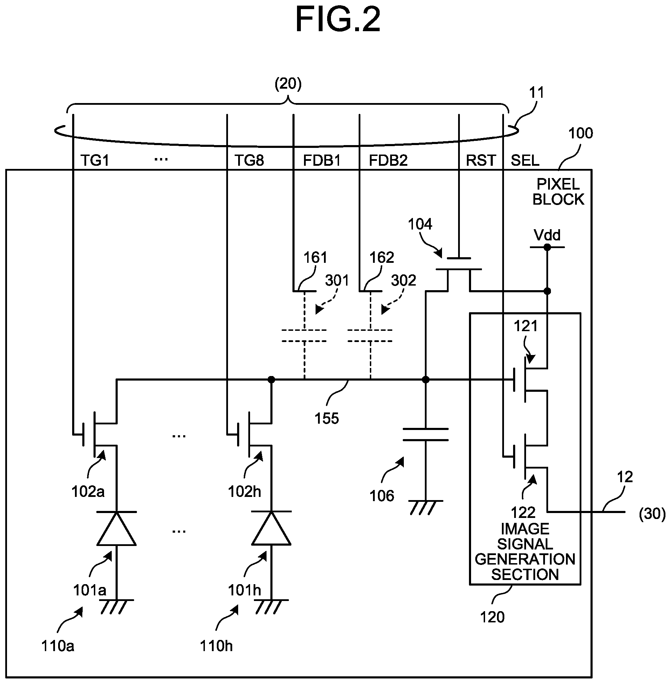

FIG. 2 is a diagram illustrating a configuration example of a pixel block according to a first embodiment of the present disclosure. The drawing is a circuit diagram illustrating a configuration example of the pixel block 100. The pixel block 100 in the drawing includes pixels 110a to 110h, the charge holding section 106, a reset transistor 104, the image signal generation section 120, and capacitive coupling wirings 161 and 162.

The pixel 110a includes a photoelectric conversion section 101a and a charge transfer section 102a. The pixel 110b includes a photoelectric conversion section 101b and a charge transfer section 102b. The pixel 110c includes a photoelectric conversion section 101c and a charge transfer section 102c. The pixel 110d includes a photoelectric conversion section 101d and a charge transfer section 102d. The pixel 110e includes a photoelectric conversion section 101e and a charge transfer section 102e. The pixel 110f includes a photoelectric conversion section 101f and a charge transfer section 102f. The pixel 110g includes a photoelectric conversion section 101g and a charge transfer section 102g. The pixel 110h includes a photoelectric conversion section 101h and a charge transfer section 102h. Note that description of the pixels 110b to 110g is omitted. A photodiode can be used as the photoelectric conversion sections 101a to 101h. An n-channel MOS transistor can be used for the charge transfer sections 102a to 102h.

The image signal generation section 120 includes an amplification transistor 121 and a selection transistor 122. As the reset transistor 104, the amplification transistor 121, and the selection transistor 122, n-channel MOS transistors can be used. In this n-channel MOS transistor, a drain and a source can be conducted by applying a voltage exceeding a threshold value of a gate-source voltage Vgs to the gate. Hereinafter, a voltage exceeding the threshold value of the gate-source voltage Vgs is referred to as an ON voltage. In addition, the control signal including the ON voltage is referred to as an ON signal. The control signal is transmitted by the signal line TG1 or the like.

As described above, the signal line 11 and the signal line 12 are wired in the pixel block 100. The signal lines 11 in the drawing include signal lines TG1 to TG8, a signal line FDB1, a signal line FDB2, a signal line RST, and a signal line SEL. In addition, a power supply line Vdd is wired to the pixel block 100. The power supply line Vdd is a wiring that supplies power to the pixel block 100.

The anode of the photoelectric conversion section 101a is grounded, and the cathode is connected to the source of the charge transfer section 102a. The anode of the photoelectric conversion section 101b is grounded, and the cathode is connected to the source of the charge transfer section 102b. The anode of the photoelectric conversion section 101c is grounded, and the cathode is connected to the source of the charge transfer section 102c. The anode of the photoelectric conversion section 101d is grounded, and the cathode is connected to the source of the charge transfer section 102d. The anode of the photoelectric conversion section 101e is grounded, and the cathode is connected to the source of the charge transfer section 102e. The anode of the photoelectric conversion section 101f is grounded, and the cathode is connected to the source of the charge transfer section 102f. The anode of the photoelectric conversion section 101g is grounded, and the cathode is connected to the source of the charge transfer section 102g. The anode of the photoelectric conversion section 101h is grounded, and the cathode is connected to the source of the charge transfer section 102h.

The drains of the charge transfer sections 102a to 102h are connected to the source of the reset transistor 104, the gate of the amplification transistor 121, and one end of the charge holding section 106. The other end of the charge holding section 106 is grounded. The drain of the reset transistor 104 and the drain of the amplification transistor 121 are connected to the power supply line Vdd. The source of the amplification transistor 121 is connected to the drain of the selection transistor 122, and the source of the selection transistor 122 is connected to the signal line 12.

The gates of the charge transfer sections 102a to 102h are connected to the signal lines TG1 to TG8, respectively. The capacitive coupling wirings 161 and 162 are connected to the signal lines FDB1 and FDB2, respectively. The gate of the reset transistor 104 is connected to the signal line RST, and the gate of the selection transistor 122 is connected to the signal line SEL.

The photoelectric conversion sections 101a to 101h perform photoelectric conversion of incident light. The photoelectric conversion sections 101a to 101h can include a photodiode formed on a semiconductor substrate 130 described later. The photoelectric conversion sections 101a to 101h perform photoelectric conversion of incident light in an exposure period and holds a charge generated by the photoelectric conversion.

The charge holding section 106 holds the charge generated by the photoelectric conversion sections 101a to 101h. The charge holding section 106 can be configured by a floating diffusion region (FD) which is a semiconductor region formed in the semiconductor substrate 130.

The charge transfer sections 102a to 102h transfer the charges. The charge transfer sections 102a to 102h transfer the charges generated by the photoelectric conversion sections 101a to 101h to the charge holding section 106. The charge transfer section 102a and the like transfer charges by electrically connecting the photoelectric conversion section 101a and the like to the charge holding section 106. The control signals of the charge transfer sections 102a to 102h are transmitted by the signal lines TG1 to TG8, respectively.

The reset transistor 104 resets the charge holding section 106. This reset can be performed by electrically connecting the charge holding section 106 and the power supply line Vdd to discharge the charge of the charge holding section 106. A control signal of the reset transistor 104 is transmitted by the signal line RST.

The image signal generation section 120 generates an image signal on the basis of the charge held in the charge holding section 106. As described above, the image signal generation section 120 includes the amplification transistor 121 and the selection transistor 122.

The amplification transistor 121 amplifies the voltage of the charge holding section 106. the gate of the amplification transistor 121 is connected to the charge holding section 106. Therefore, an image signal having a voltage corresponding to the charge held in the charge holding section 106 is generated at the source of the amplification transistor 121. Further, by making the selection transistor 122 conductive, this image signal can be output to the signal line 12. A control signal of the selection transistor 122 is transmitted by the signal line SEL.

The photoelectric conversion sections 101a to 101h perform photoelectric conversion of incident light during an exposure period to generate a charge, and accumulates the charge in itself. After the lapse of the exposure period, the charge transfer sections 102a to 102h transfer the charges of the photoelectric conversion sections 101a to 101h to the charge holding section 106 and hold the charge. An image signal is generated by the image signal generation section 120 on the basis of the held charge.

As described above, the charge transfer sections 102a to 102h transfer the charges generated by the photoelectric conversion sections 101a to 101h to the charge holding section 106. This transfer is performed by the selected charge transfer section 102a or the like among the charge transfer sections 102a to 102h. At this time, an arbitrary charge transfer section 102a or the like is selected, and the charge is transferred. That is, one of the charge transfer sections 102a to 102h may be selected, or all of the charge transfer sections 102a to 102h may be selected. Therefore, the charge amount held in the charge holding section 106 changes according to the number of selected charge transfer sections 102a to 102h.

The capacitive coupling wirings 161 and 162 are capacitively coupled to the charge holding section 106. The capacitive coupling wirings 161 and 162 in the drawing are examples of coupling to the charge holding section 106 via a charge holding section wiring 155 which is a wiring connected to the charge holding section 106. A virtual capacitor 301 is connected between the capacitive coupling wiring 161 and the charge holding section wiring 155. A virtual capacitor 302 is connected between the capacitive coupling wiring 162 and the charge holding section wiring 155. When a voltage is applied to the capacitive coupling wirings 161 and 162, the voltage is applied to the charge holding section 106 via the capacitors 301 and 302, and the potential of the charge holding section 106 increases. Therefore, the potential of the charge holding section 106 becomes deep, and the charge holding capacitance in the charge holding section 106 can be increased.

By selecting the capacitive coupling wirings 161 and 162 to which the voltage is applied, the potential of the charge holding section 106 can be adjusted. In a case where a voltage is applied to any one of the capacitive coupling wirings 161 and 162, the potential of the charge holding section 106 can be adjusted to a lower value than in a case where a voltage is applied to both the capacitive coupling wirings 161 and 162. A voltage is applied to the capacitive coupling wirings 161 and 162 by an adjustment signal. This adjustment signal is generated by the vertical drive section 20 and transmitted by the signal lines FDB1 and FDB2.

Note that the configuration of the pixel block 100 is not limited to this example. For example, three or more capacitive coupling wirings may be arranged in the pixel block 100.

### [Configuration of Pixel]

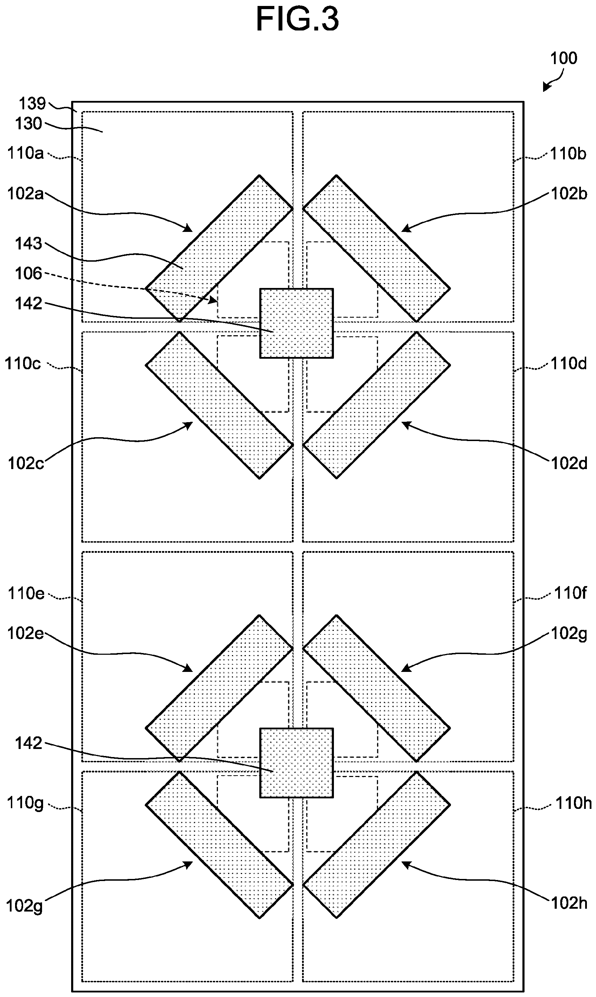

FIG. 3 is a diagram illustrating a configuration example of a pixel block according to the first embodiment of the present disclosure. The drawing is a plan view illustrating a configuration example of the pixel block 100. The pixel block 100 is formed on the semiconductor substrate 130. As illustrated in the drawing, the pixels 110a to 110h are arranged in two rows and four columns. A broken-line rectangle in the drawing represents the pixel 110a and the like. Furthermore, a separation section 139 is arranged around the pixel 110a and the like. The charge holding section 106 is divided and arranged for each of the pixels 110a to 110h. A region indicated by a dotted line in the drawing represents the charge holding section 106. Furthermore, the charge transfer section 102a and the like are arranged adjacent to the charge holding section 106. A dot-hatched rectangle in the drawing represents a gate electrode 143 of the charge transfer section 102a or the like. Each of the pixels 110a to 110d and the pixels 110e to 110h constitutes a pixel group. A pad 142 is arranged at the center of these pixel groups. The pad 142 is an electrode commonly connected to the charge holding section 106 included in the pixel group. Note that, as will be described later, the pads 142 of the respective pixel groups are commonly connected by the charge holding section wiring 155.

### [Configuration of Cross-Section of Pixel Block]

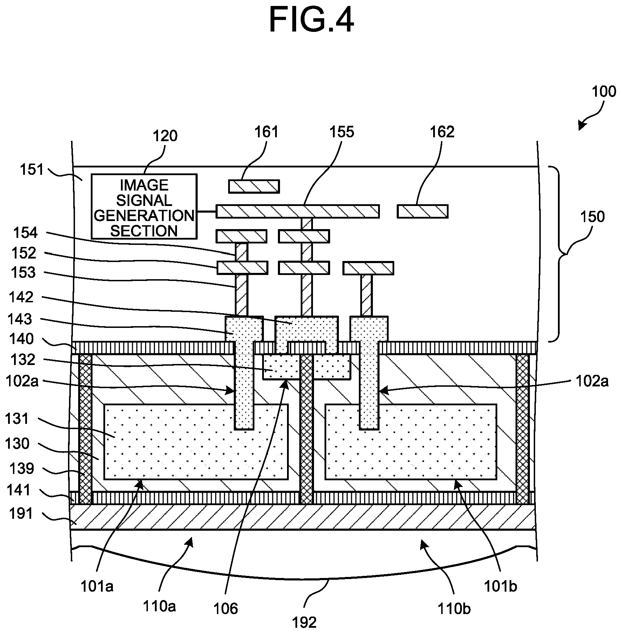

FIG. 4 is a cross-sectional view illustrating a configuration example of a pixel block according to the first embodiment of the present disclosure. The drawing is a cross-sectional view illustrating a configuration example of the pixel block 100. The pixel block 100 in the drawing includes a semiconductor substrate 130, a wiring region 150, a color filter 191, and an on-chip lens 192. Note that the pixels 110a and 110b are illustrated in the drawing. The configuration of the pixel block 100 will be described by taking the portions of the pixels 110a and 110b as an example.

The semiconductor substrate 130 is a semiconductor substrate on which the photoelectric conversion section 101 and the like are disposed. A charge transfer section 102 and the charge holding section 106 are further disposed on the semiconductor substrate 130 in the drawing. In the drawing, the photoelectric conversion sections 101a and 101b, the charge transfer sections 102a and 102b, and the charge holding section 106 are illustrated. The semiconductor substrate 130 can be constituted by, for example, silicon (Si). The photoelectric conversion section 101 and the like are arranged in a well region formed in the semiconductor substrate 130. For convenience, the semiconductor substrate 130 in the drawing is assumed to constitute a p-type well region. By arranging n-type and p-type semiconductor regions in the p-type well region, an element (diffusion layer thereof) can be formed.

A rectangle described in the semiconductor substrate 130 in the drawing represents an n-type semiconductor region. When the photoelectric conversion section 101a is described as an example, the photoelectric conversion section 101a includes an n-type semiconductor region 131. Specifically, a photodiode constituted by a pn junction formed at an interface between the n-type semiconductor region 131 and a surrounding p-type well region corresponds to the photoelectric conversion section 101a.

The charge holding section 106 includes an n-type semiconductor region 132 configured to have a relatively high impurity concentration. These n-type semiconductor regions 132 constitute the above-described FD. In addition, the pad 142 is connected to these charge holding sections 106. The pad 142 can be constituted by polycrystalline silicon implanted with impurities.

The charge transfer section 102a includes the semiconductor regions 131 and 132 and the gate electrode 143. The n-type semiconductor regions 131 and 132 correspond to the source region and the drain region of the charge transfer section 102a. The gate electrode 143 is disposed on the front surface side of the semiconductor substrate 130 and includes a columnar section having a depth reaching the n-type semiconductor region 131. When an ON voltage is applied to the gate electrode 143, a channel is formed in a well region adjacent to the gate electrode 143, and the n-type semiconductor regions 131 and 132 enter a conductive state. That is, conduction is established between the photoelectric conversion section 101a and the charge holding section 106, and the charge of the photoelectric conversion section 101a is transferred to the charge holding section 106. As described above, the charge transfer section 102a includes a vertical transistor that transfers a charge in the thickness direction of the semiconductor substrate.

The charge transfer section 102b can also adopt a configuration similar to the charge transfer section 102a. Note that the gate electrode 143 can be constituted by polycrystalline silicon implanted with impurities.

Note that insulating films 140 and 141 are disposed on the front surface side and the back surface side of the semiconductor substrate 130, respectively. The insulating films 140 and 141 can be constituted by, for example, silicon oxide (SiO₂) or silicon nitride (SiN). Note that an insulating film is also disposed between the gate electrode 143 and the semiconductor substrate 130. This insulating film corresponds to a gate insulating film.

The separation section 139 is arranged at a boundary of the pixel block 100 to separate the pixels 110. The separation section 139 can be configured by embedding an insulator such as SiO₂ in a groove section penetrating from the back surface side to the front surface side of the semiconductor substrate 130.

The wiring region 150 is a region that is disposed on the front surface side of the semiconductor substrate 130 and in which wiring for transmitting signals and the like of elements is disposed. The wiring region 150 includes an insulating layer 151, wiring 152, and the like. The insulating layer 151 insulates the gate electrode 143, the wiring 152, and the like disposed on the front surface side of the semiconductor substrate 130. The insulating layer 151 can be constituted by, for example, SiO₂.

The wiring 152 and the like can be constituted by metal such as copper (Cu). The wiring 152 can be configured in multiple layers. The wirings 152 arranged in different layers can be connected by a via plug 154 constituted by a columnar metal. Note that the wiring 152 and the gate electrode 143 and the like can be connected by a contact plug 153. Note that the via plug 154 is an example of an interlayer connection section.

In the wiring region 150 in the drawing, the charge holding section wiring 155 and the capacitive coupling wirings 161 and 162 are further arranged. The capacitive coupling wirings 161 and 162 are disposed close to the charge holding section wiring 155 and capacitively coupled to the charge holding section wiring 155. Note that the charge holding section wiring 155 in the drawing illustrates an example in which the charge holding section wiring 155 is connected to the pad 142 of the charge holding section 106 via the wiring 152, the via plug 154, and the contact plug 153 configured in multiple layers. Furthermore, the charge holding section wiring 155 is connected to the image signal generation section 120. A MOS transistor (not illustrated) constituting the image signal generation section 120 is also formed on the semiconductor substrate 130.

The color filter 191 is an optical filter that transmits light of a predetermined wavelength among the incident light. As the color filter 191, for example, a color filter that transmits red light, green light, and blue light can be used.

The on-chip lens 192 is a lens that condenses incident light. The on-chip lens 192 is formed in, for example, a hemispherical shape, and condenses incident light on the photoelectric conversion section 101a or the like. An example in which the on-chip lens 192 in the drawing is commonly arranged in the four pixels 110 is illustrated.

### [Generation of Image Signal]

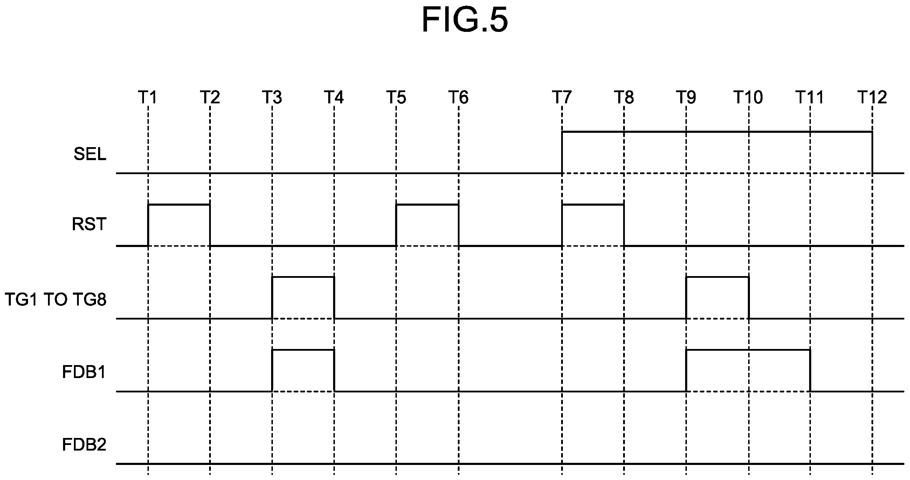

FIG. 5 is a diagram illustrating an example of generation of an image signal according to the first embodiment of the present disclosure. The drawing is a timing chart illustrating an example of generation of an image signal in the pixel block 100. "SEL" and "RST" in the drawing represent signals of the selection signal line SEL and the reset signal line RST, respectively. In addition, "TG1 to TG8" represent signals of the signal lines TG1 to TG8. In these signals, the portion having the value "1" of the binarized waveform represents the ON voltage. For example, a voltage of 3 V can be applied as the ON voltage. In addition, the portion of the value "0" represents the OFF voltage. A broken line in the drawing represents the level of the OFF voltage. As the OFF voltage, for example, 0 V or a negative voltage (for example, -1.2 V) can be applied. Further, "FDB1" and "FDB2" represent the adjustment voltages of the signal lines FDB1 and FDB2.

In the initial state, the value "0" is input to the selection signal line SEL, the reset signal line RST, and the charge transfer signal lines TG1 to TG8. In addition, the adjustment voltage is not applied to the signal lines FDB1 and FDB2.

At T1, an ON voltage is input from the signal line RST. As a result, the reset transistor 104 enters a conductive state, and the charge of the charge holding section 106 is discharged.

At T2, the input of the ON voltage of the signal line RST is stopped. As a result, the charge holding section 106 returns to a floating state.

At T3, an ON voltage is applied to TG1 or the like connected to the selected charge transfer section 102a or the like among the charge transfer sections 102a to 102h, and the selected charge transfer section 102a or the like enters a conductive state. Furthermore, an adjustment voltage is applied to the signal line FDB1, and the charge holding section 106 is boosted. As a result, the charges of the selected photoelectric conversion section 101a and the like are discharged to the charge holding section 106.

At T4, the application of the ON voltage to TG1 and the like is stopped, and the application of the adjustment voltage to the signal line FDB1 is stopped. As a result, the reset of the photoelectric conversion section 101a and the like ends, and the exposure period starts.

At T5, the ON voltage is input from the signal line RST. As a result, the reset transistor 104 enters a conductive state, and the charge of the charge holding section 106 is discharged again.

At T6, the input of the ON voltage of the signal line RST is stopped. As a result, the resetting of the charge holding section 106 ends.

At T7, the ON voltage is input from the signal line SEL and the signal line RST. As a result, the selection transistor 122 enters a conductive state. Furthermore, the reset transistor 104 enters a conductive state, and the charge accumulated in the charge holding section 106 is discharged during the period from T6 to T7.

At T8, the input of the ON voltage of the signal line RST is stopped.

At T9, an ON voltage is applied to TG1 or the like connected to the selected charge transfer sections 102a or the like among the charge transfer sections 102a to 102h, and the selected charge transfer section 102a or the like enters a conductive state. As a result, the charge of the photoelectric conversion section 101 of the selected pixel 110 is transferred to the charge holding section 106. In addition, an adjustment voltage is applied to the signal lines FDB1 and FDB2. The drawing illustrates an example in which the adjustment voltage is applied to the signal line FDB1.

At T10, the application of the ON voltage to TG1 and the like is stopped, and at T11, the application of the adjustment voltage to the signal lines FDB1 and FDB2 is stopped. As a result, the exposure period ends.

At T12, the application of the ON voltage to the signal line SEL is stopped. In the period from T7 to T12, an image signal is generated and output by the image signal generation section 120. According to the above procedure, an image signal can be generated in the pixel block 100.

In the period from T3 to T4, when the charge transfer section 102a and the like are conducted, the charge holding section 106 is boosted, thereby facilitating discharge of charges from the photoelectric conversion section 101a and the like. As a result, charges remaining in the photoelectric conversion section 101a and the like after resetting can be reduced.

Note that the procedure from T3 to T6 may be omitted, and the charge transfer section 102a and the like may be conducted during the period from T1 to T2 to reset the photoelectric conversion section 101a and the charge holding section 106.

### [Transfer of Charge]

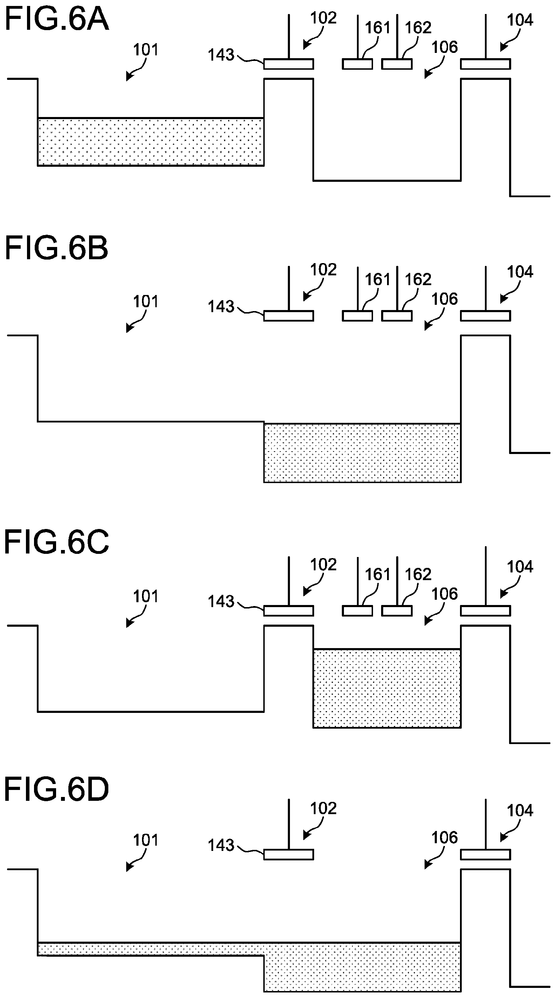

FIG. 6A to 6D are diagrams illustrating an example of a potential of a pixel according to the first embodiment of the present disclosure. The drawing is a diagram illustrating potentials of the photoelectric conversion section 101, the charge transfer section 102, the charge holding section 106, and the reset transistor 104. In addition, the capacitive coupling wirings 161 and 162 are illustrated in the drawing.

FIG. 6A illustrates a potential after the exposure time elapses. The photoelectric conversion section 101 is in a state in which charges are accumulated. A region hatched with a point in the drawing represents a charge.

FIG. 6B illustrates a state in which the ON voltage is applied to the gate electrode 143 of the charge transfer section 102. The potential of the charge transfer section 102 is deepened, and the charge transfer section 102 is conducted. At this time, by applying the ON voltage to the charge transfer section 102, the potential of the charge holding section 106 increases and the potential becomes deep. This is because the charge transfer section 102 and the charge holding section 106 are capacitively coupled. Further, an adjustment signal is applied to the capacitive coupling wirings 161 and 162. As a result, the potential of the charge holding section 106 further increases, and the potential becomes deeper. Therefore, the holding capacitance of the charge holding section 106 increases, and all the charges held in the photoelectric conversion section 101 are transferred to the charge holding section 106.

FIG. 6C illustrates a state in which the application of the ON voltage to the charge transfer section 102 is stopped. At this time, the application of the adjustment signal to the capacitive coupling wirings 161 and 162 is also stopped. The potential of the charge holding section 106 returns to the initial state. The charge holding section 106 maintains a state in which a charge is held. At this time, an image signal is generated by the image signal generation section 120.

FIG. 6D is a diagram illustrating a conventional example, and illustrates an example in a case where the capacitive coupling wirings 161 and 162 are not arranged. Although the potential of the charge holding section 106 increases due to the application of the ON voltage to the charge transfer section 102, the potential does not become sufficiently deep, so that some charges remain in the photoelectric conversion section 101. Therefore, an error occurs in the generated image signal.

As described above, the charge holding section 106 can be boosted by applying the ON voltage to the charge transfer section 102a and the like. In a case where the ON voltage is applied to the plurality of charge transfer sections 102a and the like, the potential of the charge holding section 106 further increases. This is because the plurality of ON voltages are added via the coupling capacitance. Therefore, the potential of the charge holding section 106 changes according to the number of pixels 110 to which charges are simultaneously transferred. For example, in a case where the charge of one pixel 110 is transferred, since the potential of the charge holding section 106 is low, a charge transfer residue occurs. On the other hand, in a case where the pixels 110a to 110h are selected, the ON voltage is applied to the charge transfer sections 102a to 102h, so that the charge holding section 106 is excessively boosted. In this case, there is a possibility that a defect such as generation of a white spot due to a strong electric field occurs.

Therefore, a plurality of capacitive coupling wirings 161 and 162 is arranged, and an adjustment signal is applied according to the number of pixels 110 selected simultaneously. For example, in a case where one of the pixels 110a to 110h is selected, an adjustment signal is applied to the capacitive coupling wirings 161 and 162. Furthermore, for example, in a case where half of the pixels 110a to 110h are selected, an adjustment signal is applied to any of the capacitive coupling wirings 161 and 162. Furthermore, for example, in a case where the pixels 110a to 110h are selected, a scheme of not applying an adjustment signal to the capacitive coupling wirings 161 and 162 can be adopted. As a result, even in a case where the number of pixels 110 selected at the same time changes, the potential of the charge holding section 106 can be adjusted to prevent occurrence of defects such as charge transfer residues and white spots.

The vertical drive section 20 described in FIG. 1 can select the capacitive coupling wirings 161 and 162 to which the adjustment signal is applied according to the number of simultaneously selected pixels 110 and transmit the adjustment signal via the signal lines FDB1 and FDB2.

### [Arrangement Example of Capacitive Coupling Wiring]

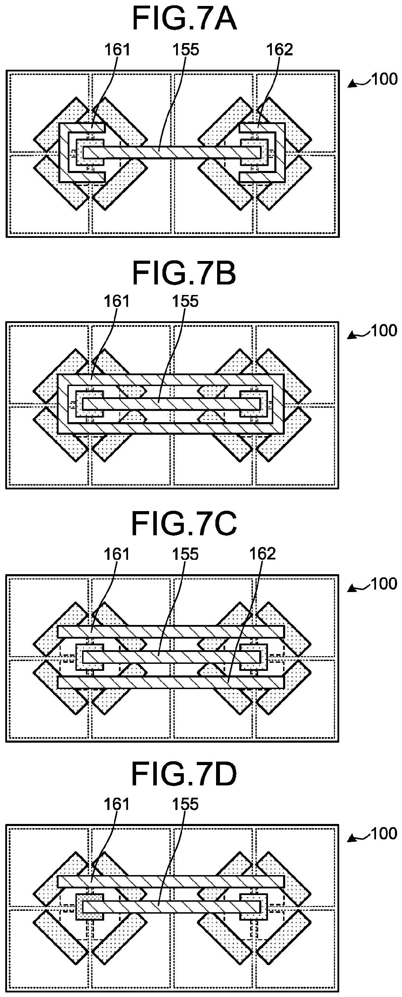

FIG. 7A to 7D are diagrams illustrating an example of capacitive coupling wiring according to the first embodiment of the present disclosure. The drawing is a diagram illustrating an example of the capacitive coupling wiring 161 and the like. Note that the charge holding section wiring 155 is illustrated in the drawing.

FIG. 7A illustrates an example of a case where the capacitive coupling wirings 161 and 162 are arranged for each pixel group. FIG. 7B illustrates an example of a case where the capacitive coupling wiring 161 having a shape surrounding the charge holding section wiring 155 is arranged. FIG. 7C illustrates an example of a case where the capacitive coupling wirings 161 and 162 are arranged on both sides of the charge holding section wiring 155. FIG. 7D illustrates an example of a case where the capacitive coupling wiring 161 having a shape along the charge holding section wiring 155 is arranged.

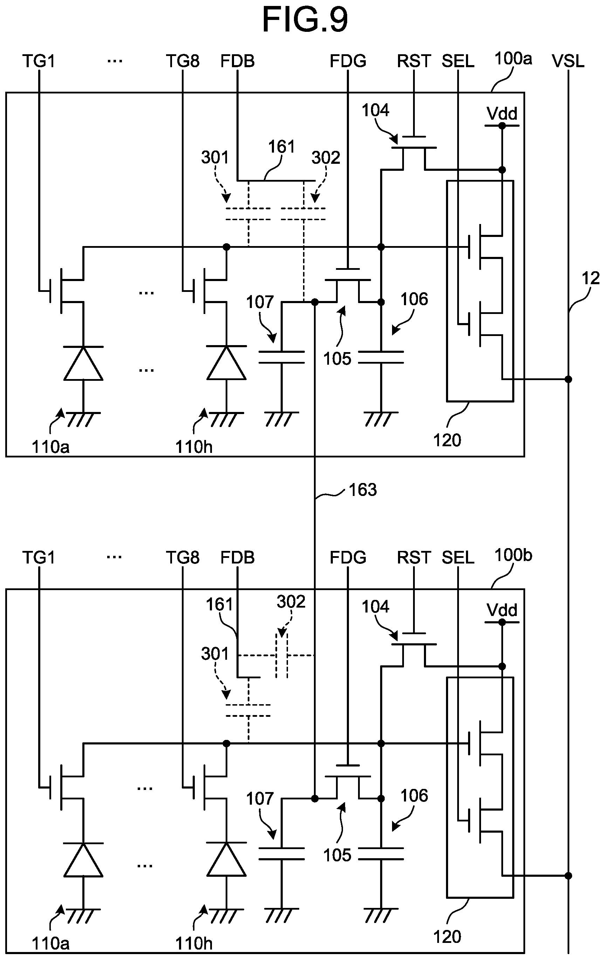

Note that, in FIGS. 7B and 7D, another capacitive coupling wiring (not illustrated) is capacitively coupled to the charge holding section wiring 155 via an auxiliary charge holding section wiring 163 (not illustrated) described in FIG. 9.

As described above, in the imaging element 1 according to the first embodiment of the present disclosure, in the pixel block 100 including the plurality of pixels 110, the plurality of capacitive coupling wirings 161 and 162 is arranged, and the adjustment signal is applied to adjust the potential of the charge holding section 106. As a result, even in a case where the number of pixels 110 to which charges are simultaneously transferred among the plurality of pixels 110 changes, the potential of the charge holding section 106 can be appropriately maintained. As a result, it is possible to prevent concentration of an excessive electric field on the charge holding section 106 while preventing a charge transfer residue.

### (2. Second Embodiment)

In the imaging element 1 of the first embodiment described above, the charge holding section 106 is arranged in the pixel block 100. On the other hand, an imaging element 1 according to a second embodiment of the present disclosure is different from the above-described first embodiment in that an auxiliary charge holding section coupled to the charge holding section 106 is further disposed.

### [Configuration of Pixel Block]

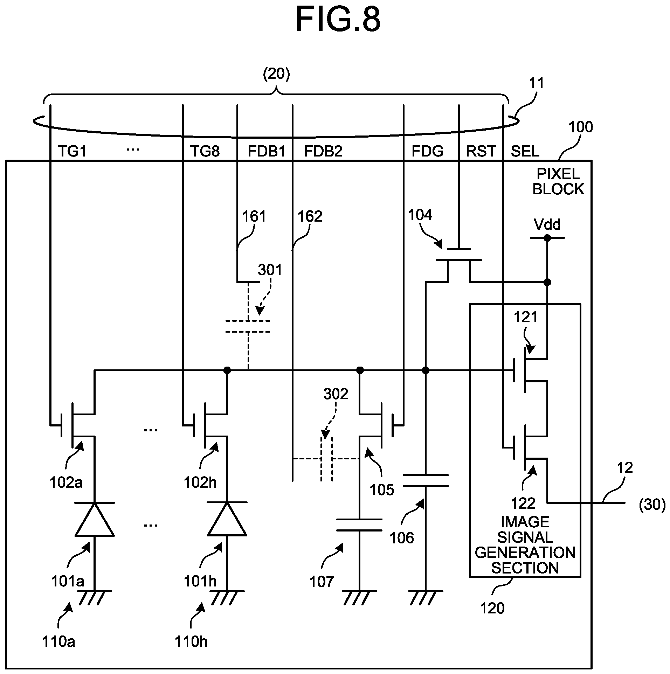

FIG. 8 is a diagram illustrating a configuration example of a pixel block 100 according to a second embodiment of the present disclosure. The drawing is a circuit diagram illustrating a configuration example of the pixel block 100 similarly to FIG. 2. The pixel block 100 in the drawing is different from the pixel block 100 in FIG. 2 in further including an auxiliary charge holding section 107 and a coupling section 105.

The auxiliary charge holding section 107 holds a charge generated by the photoelectric conversion section 101a or the like. The auxiliary charge holding section 107 holds a part of the charge transferred to the charge holding section 106. One end of the auxiliary charge holding section 107 is grounded, and the other end is connected to the coupling section 105.

The coupling section 105 couples the auxiliary charge holding section 107 and the charge holding section 106. The coupling section 105 is disposed between the auxiliary charge holding section 107 and the charge holding section 106, and is electrically connected to connect and couple the auxiliary charge holding section 107 and the charge holding section 106. The coupling section 105 can include an n-channel MOS transistor. Furthermore, a signal line FDG is connected to a gate of the coupling section 105.

By coupling the auxiliary charge holding section 107 to the charge holding section 106, the sensitivity of the pixel block 100 can be lowered. This is because the charge holding capacitance increases due to the coupling of the auxiliary charge holding section 107. In a case where an ON signal is applied to the signal line FDG and the coupling section 105 is conducted, the pixel block 100 can be set to a low-sensitivity mode. On the other hand, in a case where the ON signal is not applied to the signal line FDG, the coupling section 105 enters a non-conductive state, and the pixel block 100 can be set to a high-sensitivity mode.

The capacitive coupling wiring 162 in the drawing is an example of capacitive coupling with the auxiliary charge holding section 107. Specifically, the capacitive coupling wiring 162 is disposed close to the wiring connecting the auxiliary charge holding section 107 and the coupling section 105. The capacitive coupling wiring 162 in the drawing is capacitively coupled to the charge holding section 106 via the coupling section 105. In this manner, at least one of the capacitive coupling wirings 161 or 162 can be capacitively coupled to the auxiliary charge holding section wiring 163.

The configuration of the imaging element 1 other than this is similar to the configuration of the imaging element 1 in the first embodiment of the present disclosure, and thus description thereof is omitted.

As described above, the imaging element 1 according to the second embodiment of the present disclosure can switch the sensitivity by arranging the auxiliary charge holding section 107 in the pixel block 100.

### (3. Third Embodiment)

In the imaging element 1 of the second embodiment described above, the auxiliary charge holding section 107 is arranged in the pixel block 100. On the other hand, an imaging element 1 according to a third embodiment of the present disclosure is different from the above-described second embodiment in that auxiliary charge holding sections 107 of a plurality of pixel blocks 100 are commonly connected.

### [Configuration of Pixel Block]

FIG. 9 is a diagram illustrating a configuration example of a pixel block 100 according to a third embodiment of the present disclosure. The drawing is a circuit diagram illustrating a configuration example of the pixel block 100 similarly to FIG. 8. The pixel block 100 in the drawing is different from the pixel block 100 in FIG. 8 in being connected to another adjacent pixel block 100.

The pixel blocks 100a and 100b in the drawing are different from the pixel block 100 in FIG. 8 in that the auxiliary charge holding sections 107 are connected to each other by the auxiliary charge holding section wiring 163, and the outputs of the respective image signal generation sections 120 are commonly connected to the signal line 12. The signal line 12 in the drawing constitutes a signal line VSL.

Further, capacitive coupling wirings 161 are arranged in the pixel blocks 100a and 100b, respectively. The capacitive coupling wiring 161 in the drawing is capacitively coupled to the charge holding section 106 and the auxiliary charge holding section 107. For this reason, by conducting any coupling section 105 of the pixel blocks 100a and 100b, the capacitive coupling wiring 161 of the other pixel block 100 is capacitively coupled to the charge holding section 106 of its own pixel block 100. Therefore, the potential of the charge holding section 106 can be adjusted using the plurality of capacitive coupling wirings 161 arranged in the pixel blocks 100a and 100b, respectively.

### [Arrangement Example of Capacitive Coupling Wiring]

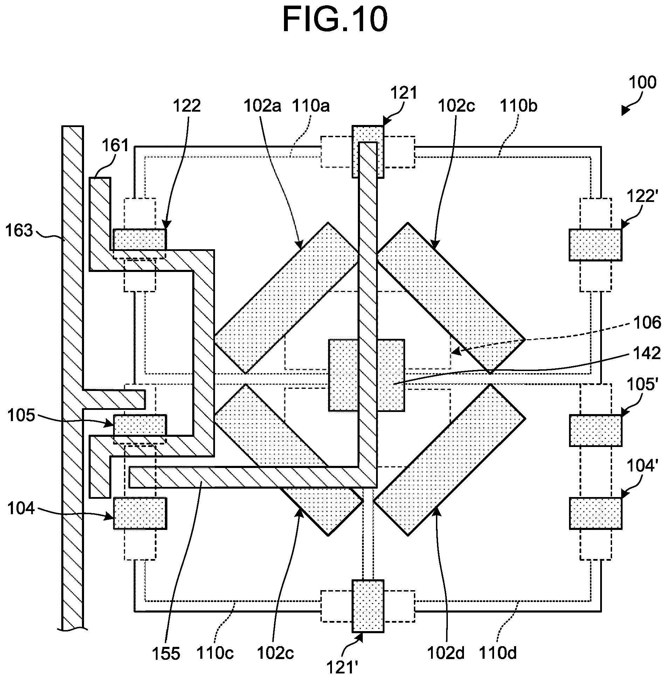

FIG. 10 is a diagram illustrating an example of a capacitive coupling wiring according to the third embodiment of the present disclosure. The drawing is a diagram illustrating an example of the capacitive coupling wiring 161 and the like. The arrangement of the capacitive coupling wirings 161 in the third embodiment of the present disclosure will be described using the pixels 110a to 110d in the drawing as an example. Note that the reset transistor 104, the coupling section 105, the amplification transistor 121, and the selection transistor 122 are illustrated in the drawing. Note that a reset transistor 104', a coupling section 105', an amplification transistor 121', and a selection transistor 122' are connected to the adjacent pixel block 100.

The auxiliary charge holding section wiring 163 in the drawing is connected to the source of the coupling section 105 in the drawing and the drain of the coupling section 105 (not illustrated) of the pixel group of the pixels 110a to 110d. Note that the stray capacitance of the auxiliary charge holding section wiring 163 can be applied to the auxiliary charge holding section 107. The charge holding section wiring 155 is connected to the pad 142, the gate of the amplification transistor 121, the source of the reset transistor 104, and the drain of the coupling section 105. The capacitive coupling wiring 161 can be arranged between the charge holding section wiring 155 and the auxiliary charge holding section wiring 163.

### [Another Configuration of Pixel Block]

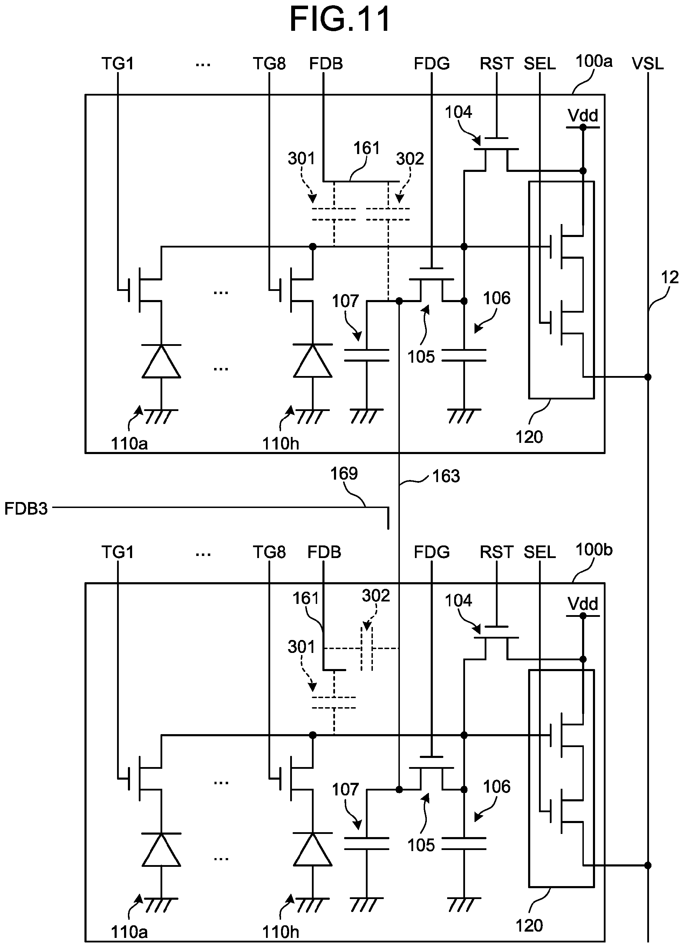

FIG. 11 is a diagram illustrating another configuration example of the pixel block according to the third embodiment of the present disclosure. The drawing is a circuit diagram illustrating a configuration example of the pixel block 100 similarly to FIG. 9. The pixel block 100 in the drawing is different from the pixel block 100 in FIG. 9 in further including a capacitive coupling wiring 169.

The capacitive coupling wiring 169 is a capacitive coupling wiring that is capacitively coupled to the auxiliary charge holding section wiring 163. The signal line FDB3 is connected to the capacitive coupling wiring 169.

### [Another Configuration of Pixel Block]

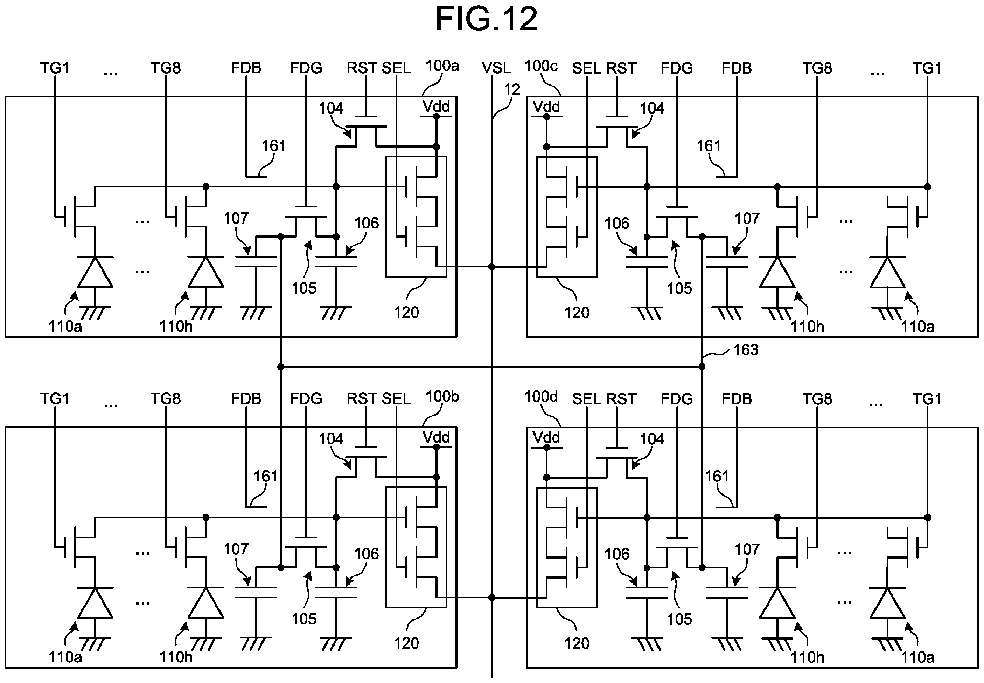

FIG. 12 is a diagram illustrating another configuration example of the pixel block according to the third embodiment of the present disclosure. The drawing is a circuit diagram illustrating a configuration example of the pixel block 100 similarly to FIG. 9. The pixel block 100 in the drawing is different from the pixel block 100 in FIG. 9 in that four adjacent pixel blocks 100 (pixel blocks 100a to 100d) are connected to each other. The auxiliary charge holding section 107 of the pixel blocks 100a to 100d is commonly connected by the auxiliary charge holding section wiring 163.

### [Arrangement Example of Pixel Block]

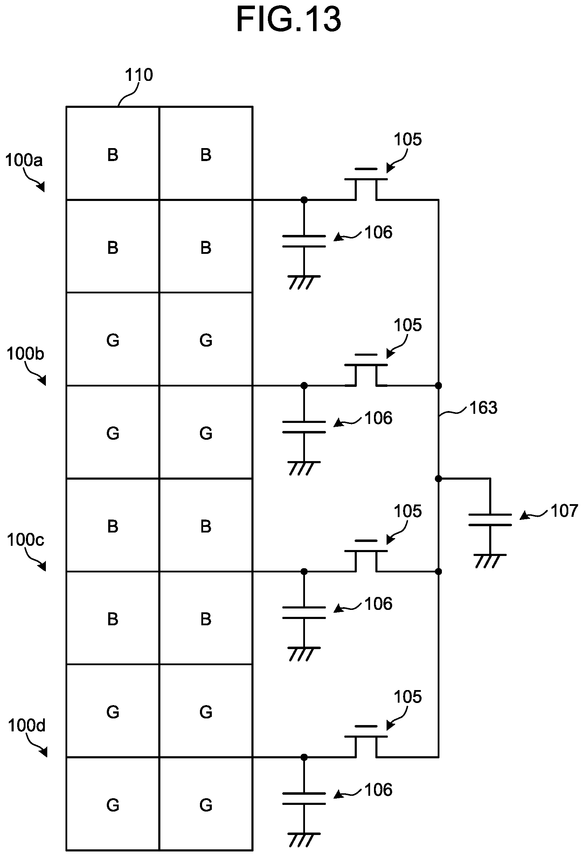

FIG. 13 is a diagram illustrating an arrangement example of pixel blocks according to the third embodiment of the present disclosure. The drawing illustrates an arrangement example of the pixel blocks 100a to 100d in FIG. 12. As illustrated in the drawing, the pixel blocks 100a to 100d can be arranged side by side in the vertical direction. Note that the characters attached to the pixels 110 in the drawing represent the types of the color filters 191 arranged in the pixel block 100. "B" in the drawing represents the color filter 191 corresponding to blue light. Further, "G" in the drawing represents the color filter 191 corresponding to green light.

As illustrated in the drawing, the coupling section 105 of the pixel blocks 100a to 100d is commonly connected to the auxiliary charge holding section 107 by the auxiliary charge holding section wiring 163.

The configuration of the imaging element 1 other than this is similar to the configuration of the imaging element 1 in the first embodiment of the present disclosure, and thus description thereof is omitted.

As described above, in the imaging element 1 according to the third embodiment of the present disclosure, the plurality of pixel blocks 100 is connected to each other, and the potential of the charge holding section 106 is adjusted by the plurality of capacitive coupling wirings 161 arranged in each pixel block 100.

### (4. Fourth Embodiment)

In the imaging element 1 of the first embodiment described above, the pixel block 100 is formed on the semiconductor substrate 130. On the other hand, an imaging element 1 according to a fourth embodiment of the present disclosure is different from the above-described third embodiment in that a pixel block 100 is formed on a plurality of semiconductor substrates.

### [Configuration of Cross-Section of Pixel Block]

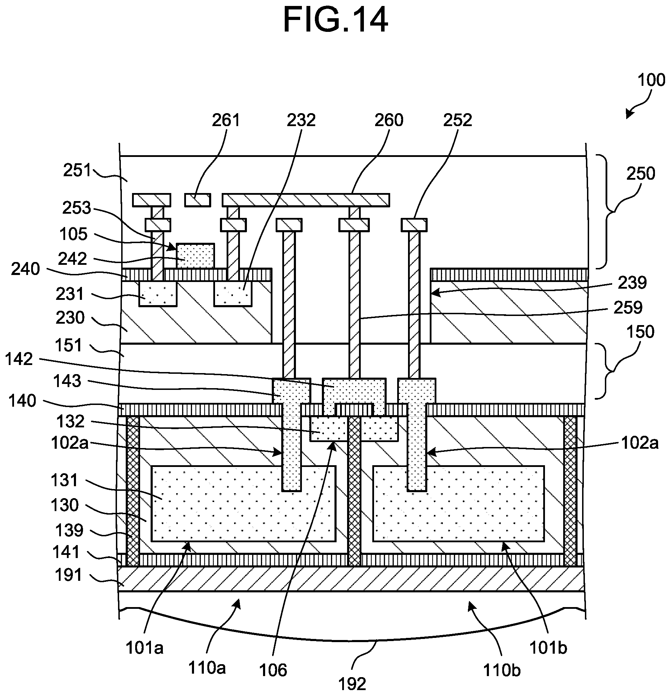

FIG. 14 is a cross-sectional view illustrating a configuration example of a pixel block according to a fourth embodiment of the present disclosure. The drawing is a cross-sectional view illustrating a configuration example of the pixel block 100 similarly to FIG. 4. The pixel block 100 in the drawing is different from the pixel block 100 in FIG. 4 in further including a semiconductor substrate 230.

The semiconductor substrate 230 is a semiconductor substrate laminated on the wiring region 150 of the semiconductor substrate 130. On the semiconductor substrate 230, the reset transistor 104, the coupling section 105, and the image signal generation section 120 are disposed. The coupling section 105 is illustrated in the drawing. The coupling section 105 in the drawing includes semiconductor regions 231 and 232 formed in the semiconductor substrate 230 and a gate electrode 242. Note that an insulating film 240 is disposed on the surface of the semiconductor substrate 230.

A wiring region 250 is disposed on the front surface side of the semiconductor substrate 230. The wiring region 250 includes an insulating layer 251 and wiring 252. Furthermore, the wiring region 250 further includes a contact plug 253 and a via plug 255 (not illustrated). The gate electrode 143 and the pad 142 of the charge transfer section 102a are connected to the wiring 252 by a via plug 259. The via plug 259 is a via plug having a shape penetrating the semiconductor substrate 230. The via plug 259 is disposed in an opening 239 formed in the semiconductor substrate 230.

In addition, a charge holding section wiring 260 and a capacitive coupling wiring 261 are arranged in the wiring region 250 in the drawing. Note that the semiconductor substrate 130 is an example of a first semiconductor substrate. The semiconductor substrate 230 is an example of a second semiconductor substrate. The via plug 259 is an example of a through-substrate connection section.

### [Arrangement Example of Capacitive Coupling Wiring]

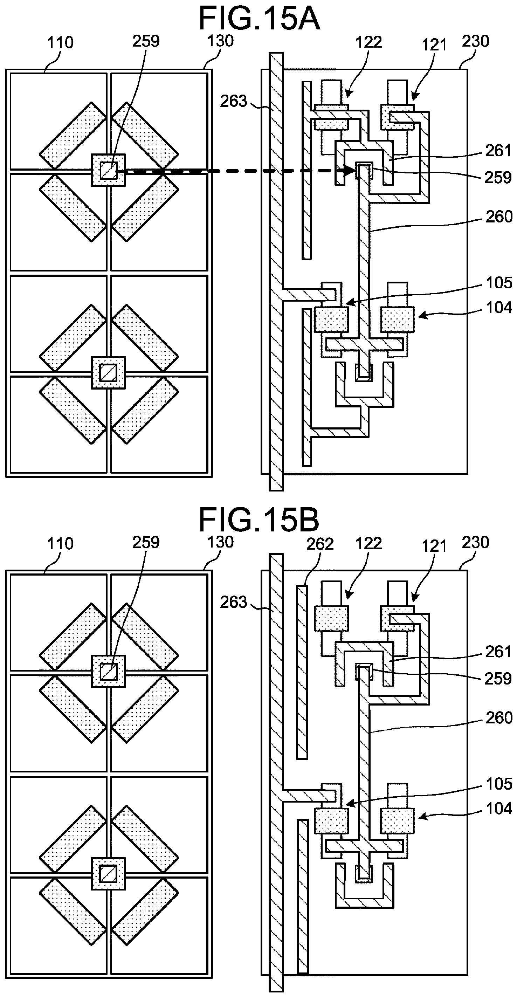

FIGS. 15A and 15B are diagrams illustrating examples of capacitive coupling wirings according to the fourth embodiment of the present disclosure. The drawing is a diagram illustrating an example of the capacitive coupling wiring 261 and the like. On the semiconductor substrate 130 in the drawing, pixels 110a to 110h constituting two pixel groups are arranged, and pads 142 are arranged for each pixel group. The reset transistor 104, the coupling section 105, and the image signal generation section 120 are arranged on the semiconductor substrate 230 in the drawing.

In addition, the charge holding section wiring 260, an auxiliary charge holding section wiring 263, and the capacitive coupling wiring 261 are arranged on the semiconductor substrate 230. The charge holding section wiring 260 is connected to the two via plugs 259, the source of the reset transistor 104, and the drain of the coupling section 105. The auxiliary charge holding section wiring 263 is connected to the source of the coupling section 105 in the drawing.

Note that the capacitive coupling wiring 261 in the drawing is arranged, for example, in the second wiring layer of the wiring region 250, and is insulated from the amplification transistor 121 and the selection transistor 122 of the semiconductor substrate 230.

FIG. 15A illustrates an example in which the capacitive coupling wiring 261 is configured in a U-shape surrounding the via plug 259 and is arranged between the charge holding section wiring 260 and the auxiliary charge holding section wiring 263.

FIG. 15B illustrates an example in which a plurality of capacitive coupling wirings (capacitive coupling wirings 261 and 262) is arranged on the semiconductor substrate 230. An example in which the capacitive coupling wiring 261 in the drawing is formed in a U shape surrounding the via plug 259 is illustrated. In addition, the capacitive coupling wiring 262 in the drawing is an example configured in a shape along the auxiliary charge holding section wiring 263.

### [Another Arrangement Example of Capacitive Coupling Wirings]

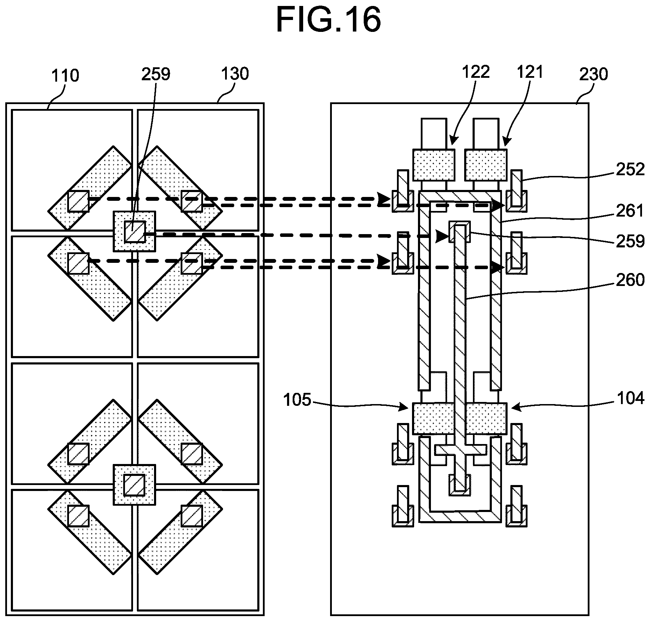

FIG. 16 is a diagram illustrating another example of the capacitive coupling wiring according to the fourth embodiment of the present disclosure. The drawing is a diagram illustrating an example of the capacitive coupling wiring 261 and the like, similarly to FIG. 15A. In the semiconductor substrates 130 and 230 of the drawing, the via plug 259 disposed in the gate electrode 143 of the charge transfer section 102a or the like is further described. The wiring 252 is connected to each of the via plugs 259 arranged in the gate electrode 143, and a control signal of the charge transfer section 102a is transmitted. These wirings 252 constitute signal lines TG1 to TG8.

The capacitive coupling wiring 261 in the drawing is an example arranged between the charge holding section wiring 260 and the wiring 252 constituting the signal lines TG1 to TG8. By arranging such capacitive coupling wiring 261, it is possible to reduce the stray capacitance between the charge holding section wiring 260 connected to the FD and the signal lines TG1 to TG8. As a result, controllability to the potential of the charge holding section 106 by the capacitive coupling wiring 261 can be improved. Note that the wiring 252 constituting the signal lines TG1 to TG8 is an example of a charge transfer signal wiring.

Note that, in the drawing, a connection portion between the charge holding section wiring 260 and the gate of the amplification transistor 121 is omitted. The charge holding section wiring 260 and the gate of the amplification transistor 121 can be connected, for example, in a second wiring layer of the wiring region 250.

The configuration of the imaging element 1 other than this is similar to the configuration of the imaging element 1 in the first embodiment of the present disclosure, and thus description thereof is omitted.

As described above, in the imaging element 1 according to the fourth embodiment of the present disclosure, the pixel block 100 includes a plurality of semiconductor substrates (semiconductor substrates 130 and 230). By laminating these semiconductor substrates, the pixel block 100 can be downsized.

### (5. Fifth Embodiment)

In the imaging element 1 of the first embodiment described above, the capacitive coupling wiring 161 capacitively coupled to the charge holding section wiring 155 is arranged in the pixel block 100. On the other hand, an imaging element 1 according to a fifth embodiment of the present disclosure is different from the above-described first embodiment in further including a via plug 164 capacitively coupled to the charge holding section wiring 155.

### [Configuration of Capacitive Coupling Wiring]

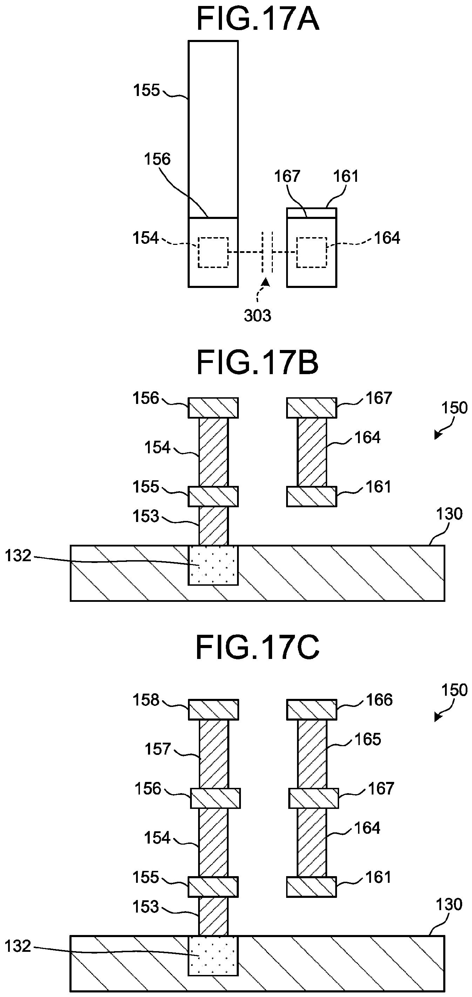

FIGS. 17A to 17C are diagrams illustrating configuration examples of capacitive coupling wirings according to the fourth embodiment of the present disclosure. FIG. 17A is a plan view illustrating a configuration example of the charge holding section wiring 155 and the capacitive coupling wiring 161. In the charge holding section wiring 155, a wiring 156 and a via plug 154 are arranged. In the capacitive coupling wiring 161, the capacitive coupling wiring 162 and the via plug 164 are arranged. Dotted rectangles in the drawing represent the via plugs 154 and 164. A virtual capacitor 303 is formed between the via plug 154 and the via plug 164.

FIG. 17B is a cross-sectional view illustrating a configuration example of the charge holding section wiring 155 and the capacitive coupling wiring 161. The via plug 154 and the wiring 156 are connected to the charge holding section wiring 155. Further, the via plug 164 and the capacitive coupling wiring 162 are connected to the capacitive coupling wiring 161. As described above, the charge holding section wiring 155 and the capacitive coupling wiring 161 are configured by multilayer wirings, and the via plugs 154 and 164 connecting the wirings are arranged close to each other, whereby the capacitance between the capacitive coupling wiring 161 and the charge holding section wiring 155 can be increased. Note that the charge holding section wiring 155 is connected to the semiconductor region 132 constituting the charge holding section 106 via the contact plug 153.

FIG. 17C illustrates an example in which the capacitive coupling wiring 161 includes three layers of wiring. The via plug 154, the wiring 156, a via plug 157, and a wiring 158 are connected to the charge holding section wiring 155 in the drawing. Further, the via plug 164, a wiring 167, a via plug 165, and a wiring 166 are connected to the capacitive coupling wiring 161. By configuring the capacitive coupling wiring 161 in multiple layers in this manner, the capacitance of the capacitive coupling wiring 161 can be further increased.

### [Configuration of Capacitive Coupling Wiring]

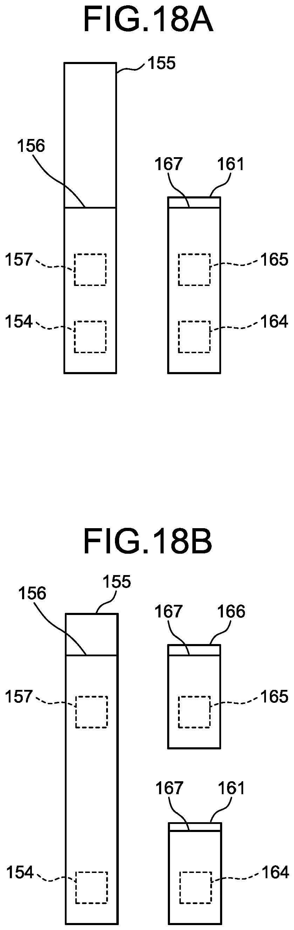

FIGS. 18A and 18B are diagrams illustrating another configuration example of the capacitive coupling wiring according to the fourth embodiment of the present disclosure. FIG. 18A illustrates an example in which a plurality of via plugs (via plugs 154 and 157) is arranged between the charge holding section wiring 155 and the wiring 156. In addition, a plurality of via plugs (via plugs 164 and 165) can also be arranged between the capacitive coupling wiring 161 and the capacitive coupling wiring 162 in the drawing.

FIG. 18B illustrates an example in which a plurality of capacitive coupling wirings is capacitively coupled to the charge holding section wiring 155. In the drawing, in addition to the capacitive coupling wiring 161, the via plug 164, and the capacitive coupling wiring 162, the wiring 166, the via plug 165, and the wiring 167 are arranged. An adjustment signal can be individually applied to the capacitive coupling wiring 161 and the wiring 166.

Note that the technology of the fourth embodiment of the present disclosure in which the via plugs 154 and 164 are arranged to increase the capacitance of the wiring can also be applied to another signal line, for example, a signal line that boosts the charge holding section 106 with a drive pulse such as a signal line RST.

The configuration of the imaging element 1 other than this is similar to the configuration of the imaging element 1 in the first embodiment of the present disclosure, and thus description thereof is omitted.

As described above, in the imaging element 1 according to the fifth embodiment of the present disclosure, the via plug 164 is disposed in the capacitive coupling wiring 161 and is disposed close to the via plug 154 of the charge holding section wiring 155. As a result, the coupling capacitance of the capacitive coupling wiring 161 can be improved.

### (6. Sixth Embodiment)

In the imaging element 1 of the fifth embodiment described above, the capacitive coupling wiring 161 capacitively coupled to the charge holding section wiring 155 in the pixel block 100 is arranged in the wiring region of the semiconductor substrate 130. On the other hand, an imaging element 1 according to a sixth embodiment of the present disclosure is different from the above-described fifth embodiment in that capacitive coupling wirings are arranged in a wiring region 250 of the semiconductor substrate 230.

### [Configuration of Capacitive Coupling Wiring]

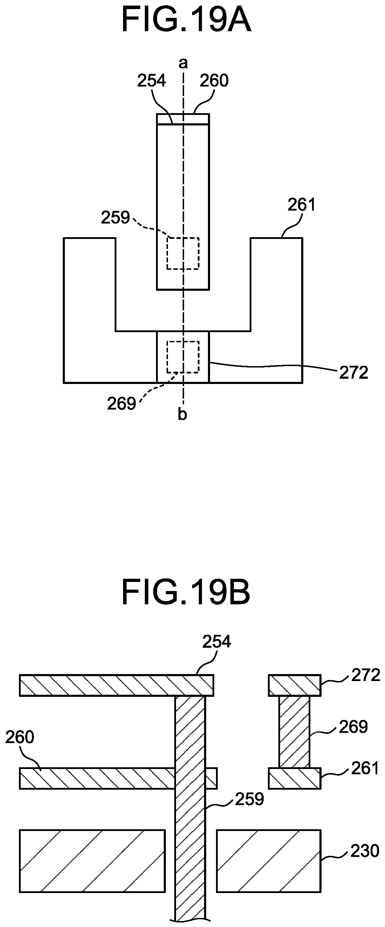

FIGS. 19A and 19B are diagrams illustrating configuration examples of capacitive coupling wirings according to the sixth embodiment of the present disclosure. FIG. 19A is a plan view illustrating a configuration example of the charge holding section wiring 260 and the capacitive coupling wiring 261. The via plug 259 described in FIG. 14 is arranged in the charge holding section wiring 260. The via plug 259 is formed in a shape extending to the position of a wiring 254 of the second layer of the wiring region 250. The capacitive coupling wiring 261 is formed in a U shape surrounding the via plug 259, and a via plug 269 and a wiring 272 are arranged.

FIG. 19B is a cross-sectional view taken along line a-b in FIG. 19A. The via plug 259 in the drawing is configured in a shape penetrating the semiconductor substrate 230, penetrating the charge holding section wiring 260, and reaching the wiring 254. The via plug 259 and the via plug 269 are disposed close to each other.

### [Another Configuration of Capacitive Coupling Wiring]

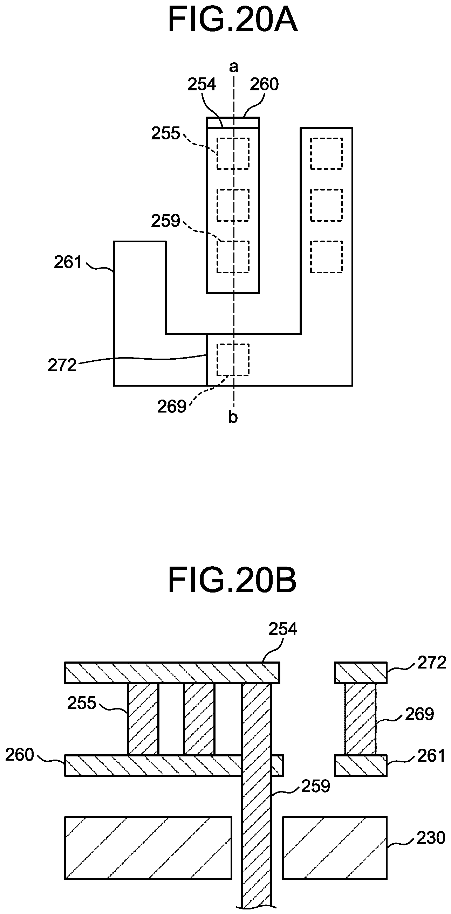

FIGS. 20A and 20B are diagrams illustrating another configuration example of the capacitive coupling wiring according to the sixth embodiment of the present disclosure. FIG. 20A is a plan view illustrating a configuration example of the charge holding section wiring 260 and the capacitive coupling wiring 261. Furthermore, FIG. 20B is a cross-sectional view taken along line a-b in FIG. 20A. A plurality of via plugs 255 is arranged between the charge holding section wiring 260 and the wiring 254 in the drawing. In addition, a plurality of via plugs 269 is also arranged between the capacitive coupling wiring 261 and the wiring 272 in the drawing. The coupling capacitance of the capacitive coupling wiring 261 can be increased by the plurality of via plugs.

### [Another Configuration of Capacitive Coupling Wiring]

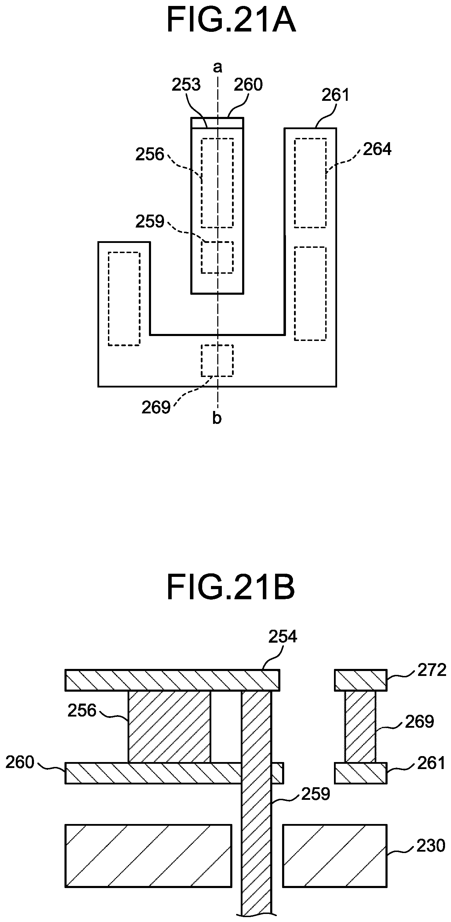

FIGS. 21A and 21B are diagrams illustrating another configuration example of the capacitive coupling wiring according to the sixth embodiment of the present disclosure. FIG. 21A is a plan view illustrating a configuration example of the charge holding section wiring 260 and the capacitive coupling wiring 261. Furthermore, FIG. 21B is a cross-sectional view taken along line a-b in FIG. 21A. A via plug 256 is disposed between the charge holding section wiring 260 and the wiring 254 in the drawing. The via plug 256 is a via plug configured in a band shape. Furthermore, a via plug 269 configured in a band shape is also arranged between the capacitive coupling wiring 261 and the wiring 272 in the drawing. The via plugs 256 and 269 can be formed by a dual damascene method. By arranging the band-shaped via plugs 256 and 269, it is possible to increase the facing areas of the via plugs 256 and 269, and it is possible to further increase the coupling capacitance of the capacitive coupling wiring 261.

### [Another Configuration of Capacitive Coupling Wiring]

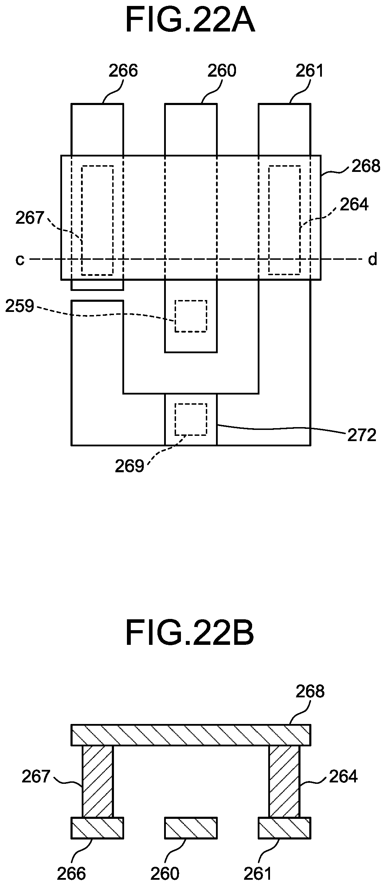

FIGS. 22A and 22B are diagrams illustrating another configuration example of the capacitive coupling wiring according to the sixth embodiment of the present disclosure. FIG. 22A is a plan view illustrating a configuration example of the charge holding section wiring 260 and the capacitive coupling wiring 261. Furthermore, FIG. 22B is a cross-sectional view taken along line a-b in FIG. 22A. In the capacitive coupling wiring 261 in the drawing, a via plug 267 and a via plug 264 are arranged. The wiring 272 is connected to the via plug 267. In addition, a capacitive coupling wiring 266 is further arranged, and the via plug 267 is arranged in the capacitive coupling wiring 266. The via plug 267 is a via plug configured in a band shape similarly to the via plug 264. In addition, a wiring 268 is connected to the via plugs 264 and 267. The wiring 268 is a wiring arranged in the second layer of the wiring region 250.

As illustrated in FIG. 22B, the charge holding section wiring 260 can be configured in a shape surrounded by the capacitive coupling wiring 261, the via plug 264, the wiring 268, the via plug 267, and the capacitive coupling wiring 266. As a result, the coupling capacitance of the capacitive coupling wiring 261 can be further increased.

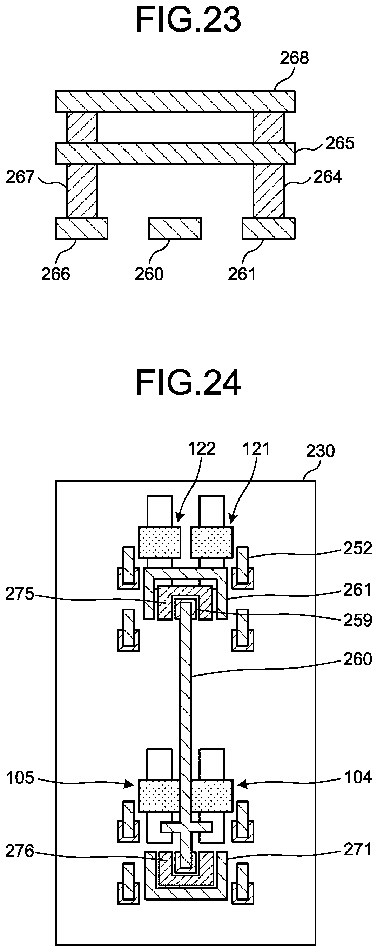

FIG. 23 is a diagram illustrating another configuration example of the capacitive coupling wiring according to the sixth embodiment of the present disclosure. The drawing is a cross-sectional view illustrating a configuration example of the charge holding section wiring 260 and the capacitive coupling wiring 261, similarly to FIG. 22B. The capacitive coupling wiring in the drawing is different from the capacitive coupling wiring in FIG. 22B in that a wiring 265 is further disposed below the wiring 268. The wiring 265 can be constituted by polycrystalline silicon implanted with impurities.

The configuration of the imaging element 1 other than this is similar to the configuration of the imaging element 1 in the fifth embodiment of the present disclosure, and thus description thereof is omitted.

As described above, the imaging element 1 according to the sixth embodiment of the present disclosure can increase the coupling capacitance of the capacitive coupling wiring 261 in the pixel block 100 configured by laminating the semiconductor substrates 130 and 230.

### (7. Seventh Embodiment)

The imaging element 1 of the above-described fourth embodiment includes the wiring region 250 including the charge holding section wiring 260, the capacitive coupling wiring 261, and the insulating layer 251. On the other hand, an imaging element 1 according to a seventh embodiment of the present disclosure is different from that of the above-described fourth embodiment in that a second insulating layer having a dielectric constant different from that of the insulating layer 251 is further disposed.

### [Configuration of Imaging Element]

FIG. 24 is a diagram illustrating a configuration example of an imaging element according to a seventh embodiment of the present disclosure. The drawing is a plan view illustrating a configuration example of the pixel 110 similarly to FIG. 16. Furthermore, the drawing is a diagram for explaining the arrangement of the charge holding section wiring 260 and the like in the semiconductor substrate 230. In the drawing, the capacitive coupling wirings 261 and 271 are illustrated. The charge holding section wiring 260 and the capacitive coupling wirings 261 and 271 are arranged in the wiring region 250 described in FIG. 14 and insulated by the insulating layer 251.

Second insulating layers 275 and 276 are disposed in the wiring region 250 in the drawing. The second insulating layers 275 and 276 are insulating layers configured to have a higher dielectric constant than the insulating layer 251. These second insulating layers 275 and 276 can be constituted by SiN, for example. The second insulating layer 275 is disposed between the charge holding section wiring 260 and the capacitive coupling wiring 261. The second insulating layer 276 is disposed between the charge holding section wiring 260 and the capacitive coupling wiring 271.

Usually, the insulating layer 251 used for the wiring region 250 and the like is constituted by a member having a relatively low dielectric constant. This is to reduce parasitic capacitance of the wiring and reduce propagation delay of a signal in the wiring and the like. On the other hand, in the wiring to which a large capacitance is added, an insulating layer including a member having a relatively high dielectric constant is disposed in the vicinity. As a result, the parasitic capacitance of the wiring can be increased.

The charge holding section wiring 260 is a wiring connected to the charge holding section 106, and corresponds to a wiring that adds a relatively large capacitance. By disposing the second insulating layer 275 and the like in the vicinity of the charge holding section wiring 260, the capacitance added to the charge holding section wiring 260 can be increased.

In the drawing, the second insulating layer 275 is disposed between the capacitive coupling wiring 261 and the charge holding section wiring 260. As a result, the coupling capacitance between the capacitive coupling wiring 261 and the charge holding section wiring 260 can be increased, and the boosting amount of the charge holding section 106 by the capacitive coupling wiring 261 can be improved. Similarly, the second insulating layer 276 is disposed between the capacitive coupling wiring 271 and the charge holding section wiring 260. As a result, the coupling capacitance between the capacitive coupling wiring 271 and the charge holding section wiring 260 can be increased, and the boosting amount of the capacitive coupling wiring 271 can be improved.

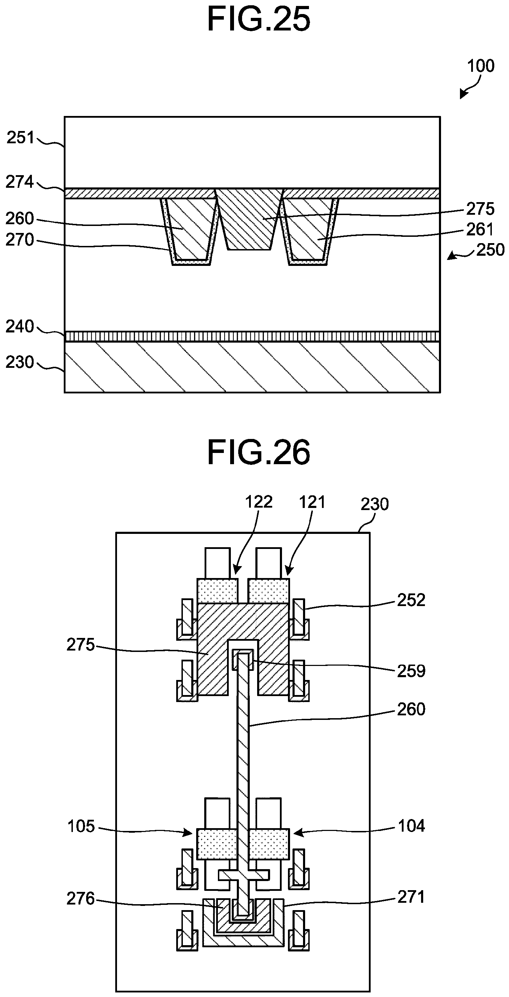

FIG. 25 is a cross-sectional view illustrating a configuration example of an imaging element according to the seventh embodiment of the present disclosure. The drawing is a cross-sectional view illustrating a configuration example of the second insulating layer 275. In the drawing, the charge holding section wiring 260 and the capacitive coupling wiring 261 are further illustrated. A barrier metal film 270 is disposed between the charge holding section wiring 260 and the capacitive coupling wiring 261, and the insulating layer 251. The barrier metal film 270 is a film that prevents diffusion of members constituting the charge holding section wiring 260 and the like, and can be constituted by titanium (Ti), for example. In addition, a diffusion prevention film 274 is arranged between the insulating layer 251 on the upper surface of the charge holding section wiring 260 and the capacitive coupling wiring 261. The diffusion prevention film 274 is a film that prevents diffusion of members constituting the charge holding section wiring 260 and the like, and can be constituted by, for example, silicon nitride carbide (SiCN).

As illustrated in the drawing, the second insulating layer 275 can be arranged in a shape embedded in the insulating layer 251 between the charge holding section wiring 260 and the capacitive coupling wiring 261. Note that insulating layer 251 is an example of the first insulating layer.

### [Another Configuration of Imaging Element]

FIG. 26 is a diagram illustrating another configuration example of the imaging element according to the seventh embodiment of the present disclosure. The drawing is a plan view illustrating a configuration example of the pixel 110 similarly to FIG. 24. The pixel 110 in the drawing is different from the pixel 110 in FIG. 24 in that the capacitive coupling wiring 261 is omitted.

The second insulating layer 275 in the drawing is disposed between the wiring 252 and the charge holding section wiring 260 constituting the charge transfer signal wiring. As a result, the coupling capacitance between the wiring 252 and the charge holding section wiring 260 can be increased, and the boosting amount of the charge holding section 106 by the wiring 252 can be improved.

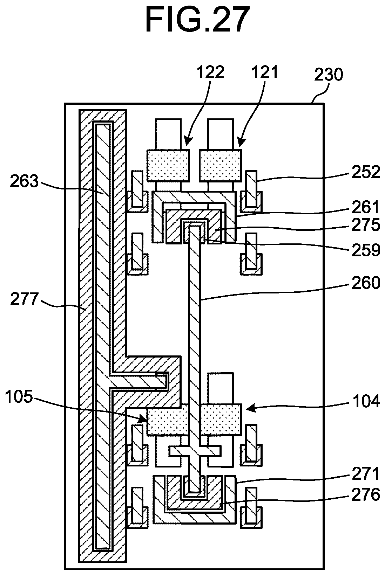

FIG. 27 is a diagram illustrating another configuration example of the imaging element according to the seventh embodiment of the present disclosure. The drawing is a plan view illustrating a configuration example of the pixel 110 similarly to FIG. 24. The pixel 110 in the drawing is different from the pixel 110 in FIG. 24 in that the auxiliary charge holding section wiring 263 and a second insulating layer 277 described in FIG. 15A are further disposed.

The second insulating layer 277 in the drawing is a second insulating layer disposed in the vicinity of the auxiliary charge holding section wiring 263. The second insulating layer 277 in the drawing illustrates an example configured in a shape arranged around the auxiliary charge holding section wiring 263. By disposing the second insulating layer 277 in the vicinity of the auxiliary charge holding section wiring 263, the parasitic capacitance of the auxiliary charge holding section wiring 263 can be increased. When the capacitance of the auxiliary charge holding section wiring 263 is used as the auxiliary charge holding section, the capacitance of the auxiliary charge holding section can be increased. Furthermore, when a desired capacitance is added to the auxiliary charge holding section wiring 263, the size of the auxiliary charge holding section wiring 263 can be reduced by arranging the second insulating layer 277.

Note that the charge holding section wiring 260 and the capacitive coupling wirings 261 and 271 can be arranged in the first layer of the wiring region 250, and the auxiliary charge holding section wiring 263 can be arranged in the second layer of the wiring region 250. In this case, the second insulating layers 275 and 276 are disposed in the first layer of the wiring region 250, and are disposed in the second layer of the wiring region 250 of the second insulating layer 277.

### [Method of Manufacturing Imaging Element]

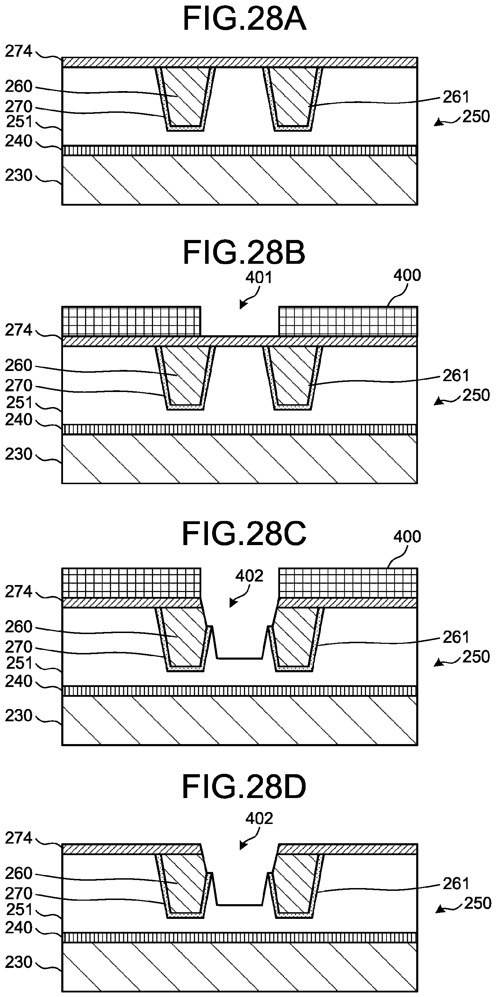

FIGS. 28A to 28G are diagrams illustrating a method of manufacturing the imaging element according to the seventh embodiment of the present disclosure. The drawing is a diagram illustrating a manufacturing process of a portion of the second insulating layer 275 in the pixel 110. First, the insulating film 240 is formed on the front surface side of the semiconductor substrate 230, and the insulating layer 251 is disposed. An opening is formed in the insulating layer 251, the barrier metal film 270 is arranged, and Cu is then embedded to form the charge holding section wiring 260 and the capacitive coupling wiring 261. The diffusion prevention film 274 is arranged on the surfaces of the charge holding section wiring 260, the capacitive coupling wiring 261, and the insulating layer 251 (FIG. 28A). As a result, the wiring region 250 including the wiring of the first layer can be formed.

Next, a resist 400 is disposed on the surface of the wiring region 250. In the resist 400, an opening 401 is disposed in a region where the second insulating layer 275 is to be formed (FIG. 28B).

Next, the wiring region 250 is etched using the resist 400 as a mask. For this etching, for example, dry etching can be applied. As a result, an opening 402 is formed in the wiring region 250 (FIG. 28C).

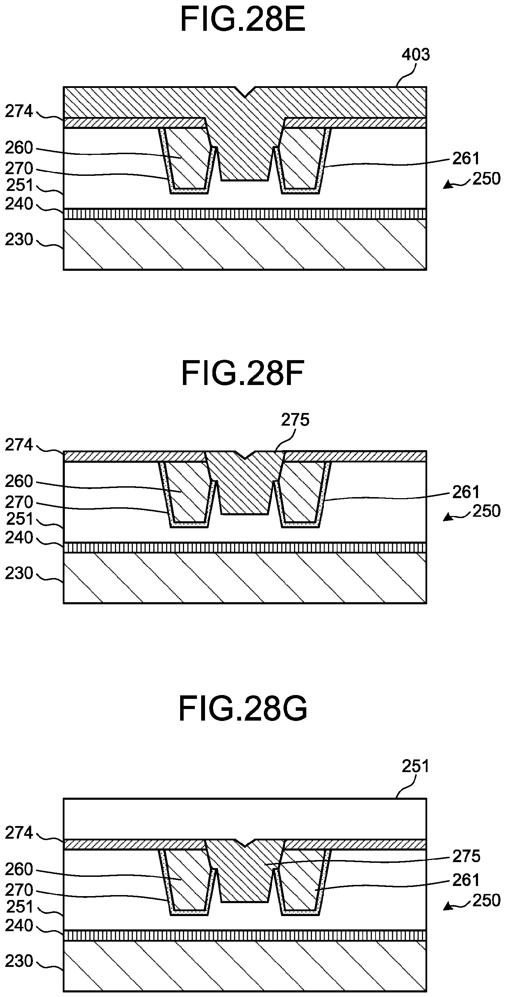

Next, the resist 400 is removed (FIG. 28D), and a material film 403 of the second insulating layer 275 is disposed. This can be performed, for example, by chemical vapor deposition (CVD) (FIG. 28E).

Next, the surface of the wiring region 250 is ground to form the second insulating layer 275. This can be done, for example, by chemical mechanical polishing (CMP) (FIG. 28F).

Next, the insulating layer 251 is disposed on the surface of the wiring region 250 (FIG. 28G). Through the above steps, the second insulating layer 275 can be formed in the wiring region 250.

Note that the configuration of the second insulating layer 275 is not limited to this example. For example, the second insulating layer 275 can also be disposed between the charge holding section wiring 155 and the capacitive coupling wirings 161 and 162 formed in the wiring region 150 of the semiconductor substrate 130. In this case, the insulating layer 151 in the wiring region 150 is an example of a first insulating layer.

As described above, by disposing the second insulating layer 275 having a dielectric constant higher than that of the insulating layer 251 in the vicinity of the charge holding section wiring 260, the capacitance added to the charge holding section wiring 260 can be increased.

### (8. Eighth Embodiment)

In the imaging element 1 of the seventh embodiment described above, the second insulating layer 275 is disposed in the vicinity of the charge holding section wiring 260. On the other hand, in an eighth embodiment of the present disclosure, variations of the second insulating layer will be described.

### [Configuration of Semiconductor Element]

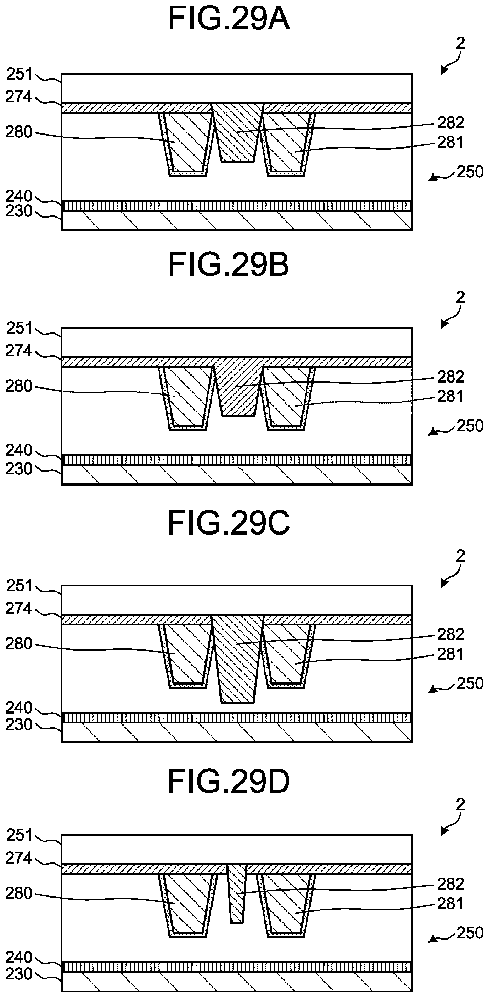

FIGS. 29A to 29D are diagrams illustrating a configuration example of a semiconductor element according to the eighth embodiment of the present disclosure. The drawing is a diagram for explaining an example in which a second insulating layer is applied to the semiconductor element 2 including the imaging element 1. The semiconductor element 2 includes the semiconductor substrate 130 and the wiring region 250. In addition, a first wiring 280 and a second wiring 281 are arranged in the wiring region 250.

FIG. 29A illustrates an example of a second insulating layer 282 disposed between the first wiring 280 and the second wiring. Similarly to the second insulating layer 275 described above, the second insulating layer 282 is an insulating layer having a higher dielectric constant than the insulating layer 251.

FIG. 29B illustrates an example of the second insulating layer 282 including the same member as the diffusion prevention film 274.

FIG. 29C illustrates an example of the second insulating layer 282 whose bottom section is formed in a shape deeper than the first wiring 280 and the second wiring 281.

FIG. 29D illustrates an example of the second insulating layer 282 formed in a shape separated from the first wiring 280 and the second wiring 281.

### [Another Configuration of Semiconductor Element]

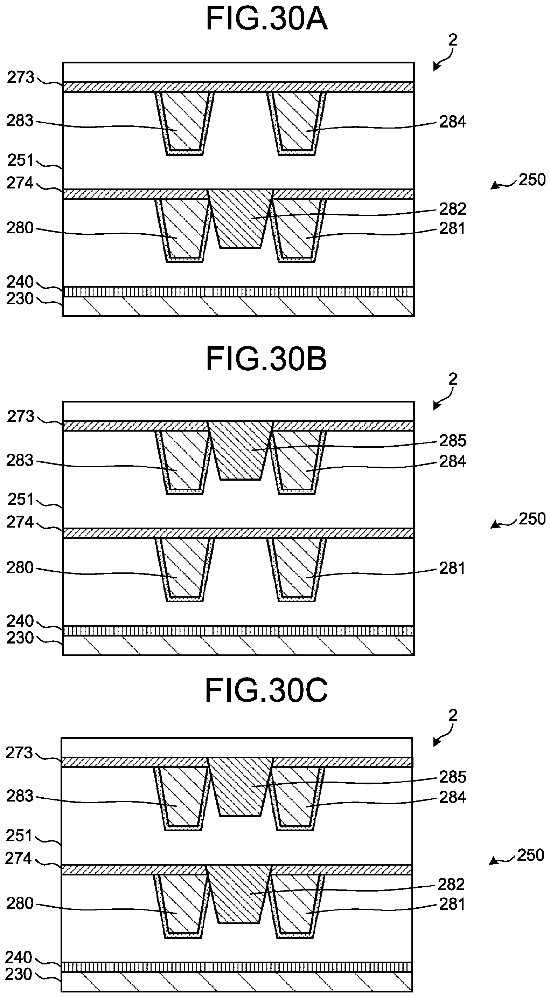

FIGS. 30A to 30C are diagrams illustrating another configuration example of the semiconductor element according to the eighth embodiment of the present disclosure. The drawing illustrates an example of a case where the wiring region 250 includes a plurality of wiring layers.

FIG. 30A illustrates an example of the second insulating layer 282 arranged between the first wiring 280 and the second wiring 281 arranged in the first layer of the wiring region 250.

FIG. 30B illustrates an example of a second insulating layer 285 arranged between a first wiring 283 and a second wiring 284 arranged in the second layer of the wiring region 250.

FIG. 30C illustrates an example in which the second insulating layer 282 and the second insulating layer 285 are disposed.

### [Another Configuration of Semiconductor Element]

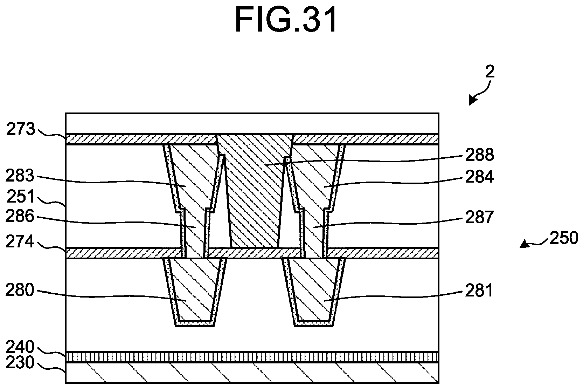

FIG. 31 is a diagram illustrating another configuration example of the semiconductor element according to the eighth embodiment of the present disclosure. The drawing illustrates an example of a case where the wiring of the first layer and the wiring of the second layer in the wiring region 250 are connected by a via plug. The first wiring 280 and the first wiring 283 are connected by a via plug 286. In addition, the second wiring 281 and the second wiring 284 are connected by a via plug 287. A second insulating layer 288 in the drawing is disposed between the first wiring 283 and the second wiring 284, and is configured in a shape in which the bottom section extends to the regions of the via plugs 286 and 287. The second insulating layer 288 in the drawing illustrates an example of being also disposed between the via plugs 286 and 287.

### [Another Configuration of Semiconductor Element]

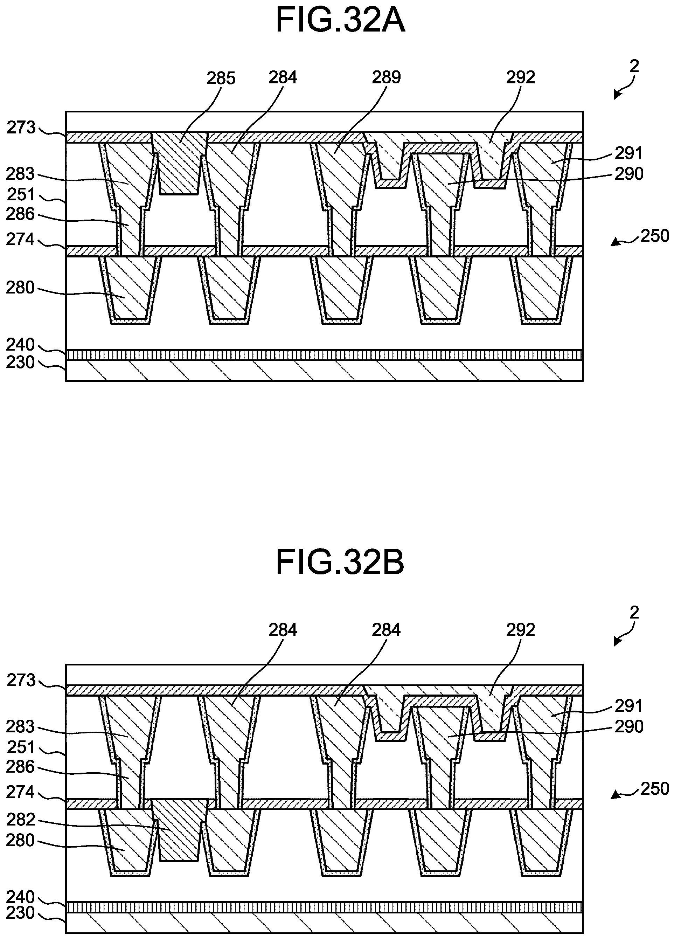

FIGS. 32A and 32B are diagrams illustrating another configuration example of the semiconductor element according to the eighth embodiment of the present disclosure. The drawing illustrates an example of a case where a third insulating layer 292 that is an insulating layer having a dielectric constant lower than that of the insulating layer 251 is provided. Wirings 289, 290, and 291 in the drawing are arranged in the second layer of the wiring region 250 and are wirings. The third insulating layer 292 is disposed between the wiring 289 and the wiring 290 and between the wiring 291 and the wiring 290. The third insulating layer 292 can include, for example, a gap.

FIG. 32A illustrates an example in which the second insulating layer 285 is disposed in the second layer of the wiring region 250.

FIG. 32B illustrates an example in which the second insulating layer 282 is disposed in the first layer of the wiring region 250.

Since the third insulating layer 292 is configured to have a relatively low dielectric constant, the parasitic capacitance of the wiring can be reduced. The third insulating layer 292 can be disposed, for example, in the vicinity of the signal line 12 constituting the signal line VSL in FIG. 9. As a result, the parasitic capacitance of the signal line 12 is reduced, and the propagation delay of the image signal transmitted by the signal line 12 can be reduced.

As described above, by disposing the second insulating layer 282 and the third insulating layer 292 having a dielectric constant different from that of the insulating layer 251 in the wiring region 250, the parasitic capacitance of the wiring can be adjusted. A high capacitance region or a low capacitance region can be formed in the same wiring region 250.

### (9. Application Example)

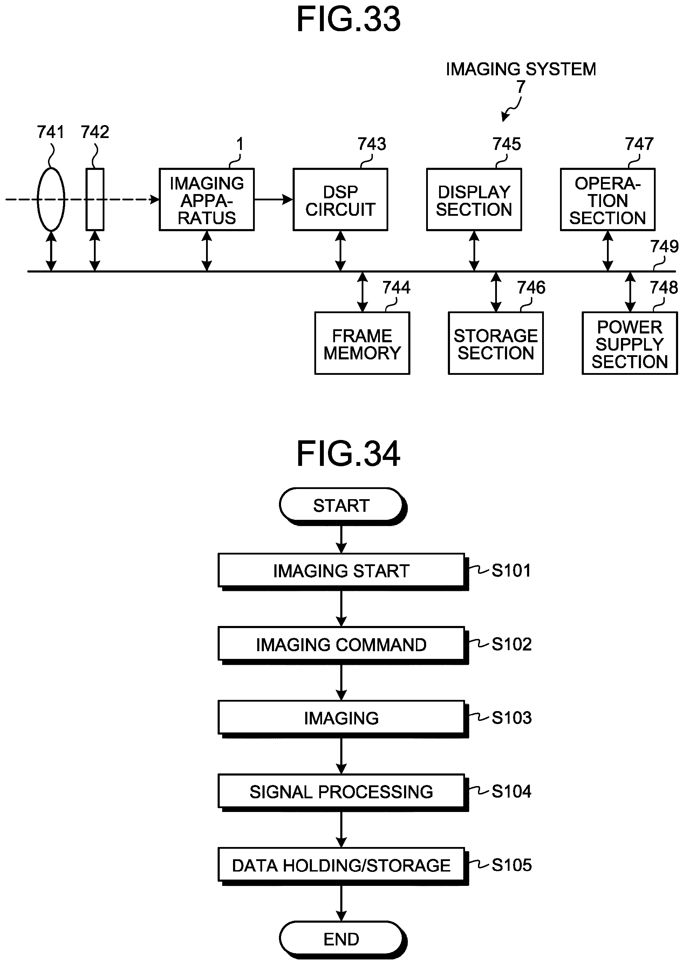

FIG. 33 illustrates an example of a schematic configuration of an imaging system 7 including the imaging apparatus 1 according to the above-described embodiments and the modifications thereof.

The imaging system 7 is, for example, an electronic device such as an imaging apparatus such as a digital still camera or a video camera, or a portable terminal apparatus such as a smartphone or a tablet terminal. The imaging system 7 includes, for example, the imaging apparatus 1, a DSP circuit 743, a frame memory 744, a display section 745, a storage section 746, an operation section 747, and a power supply section 748 according to the above-described embodiments and the modifications thereof. In the imaging system 7, the imaging apparatus 1, the DSP circuit 743, the frame memory 744, the display section 745, the storage section 746, the operation section 747, and the power supply section 748 according to the above-described embodiments and the modifications thereof are connected to each other via a bus line 749.

The imaging apparatus 1 according to the above-described embodiments and the modification thereof outputs image data according to incident light. The DSP circuit 743 is a signal processing circuit that processes a signal (image data) output from the imaging apparatus 1 according to the above-described embodiments and the modifications thereof. The frame memory 744 temporarily holds the image data processed by the DSP circuit 743 in units of frames. The display section 745 includes, for example, a panel-type display apparatus such as a liquid crystal panel or an organic electro luminescence (EL) panel, and displays a moving image or a still image captured by the imaging apparatus 1 according to the above-described embodiments and the modifications thereof. The storage section 746 records image data of a moving image or a still image captured by the imaging apparatus 1 according to the above-described embodiments and the modifications thereof in a recording medium such as a semiconductor memory or a hard disk. The operation section 747 issues operation commands for various functions of the imaging system 7 in accordance with an operation by the user. The power supply section 748 appropriately supplies various power supplies serving as operation power supplies of the imaging apparatus 1, the DSP circuit 743, the frame memory 744, the display section 745, the storage section 746, and the operation section 747 according to the above-described embodiments and the modifications thereof to these supply targets.

Next, an imaging procedure in the imaging system 7 will be described.

FIG. 34 illustrates an example of a flowchart of an imaging operation in the imaging system 7. The user instructs start of imaging by operating the operation section 747 (step S101). Then, the operation section 747 transmits an imaging command to the imaging apparatus 1 (step S102). When receiving the imaging command, the imaging apparatus 1 (specifically, the system control circuit 36) executes imaging by a predetermined imaging scheme (step S103).

The imaging apparatus 1 outputs image data obtained by imaging to the DSP circuit 743. Here, the image data is data for all the pixels of the pixel signal generated on the basis of the charge temporarily held in the floating diffusion FD. The DSP circuit 743 performs predetermined signal processing (for example, noise reduction processing or the like) on the basis of the image data input from the imaging apparatus 1 (step S104). The DSP circuit 743 causes the frame memory 744 to hold the image data subjected to predetermined signal processing, and the frame memory 744 causes the storage section 746 to store the image data (step S105). In this manner, imaging in the imaging system 7 is performed.

In the present application example, the imaging apparatus 1 according to the above-described embodiments and the modifications thereof is applied to the imaging system 7. As a result, since the imaging apparatus 1 can be downsized or high definition, it is possible to provide the small or high definition imaging system 7.

### (10. Applied Example to Mobile Body)

The technology according to the present disclosure (present technology) can be applied to various products. For example, the technology according to the present disclosure may be realized as an apparatus mounted on any type of mobile body such as an automobile, an electric vehicle, a hybrid electric vehicle, a motorcycle, a bicycle, a personal mobility, an airplane, a drone, a ship, and a robot.

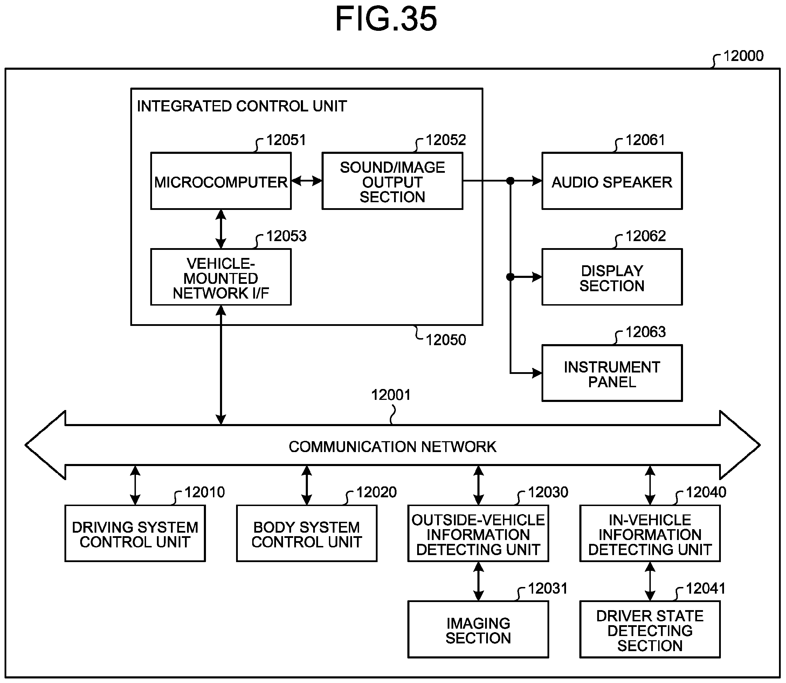

FIG. 35 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 35, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 35, an audio speaker 12061, a display section 12062, and an instrument panel 12063 are illustrated as the output device. The display section 12062 may, for example, include at least one of an on-board display and a head-up display.

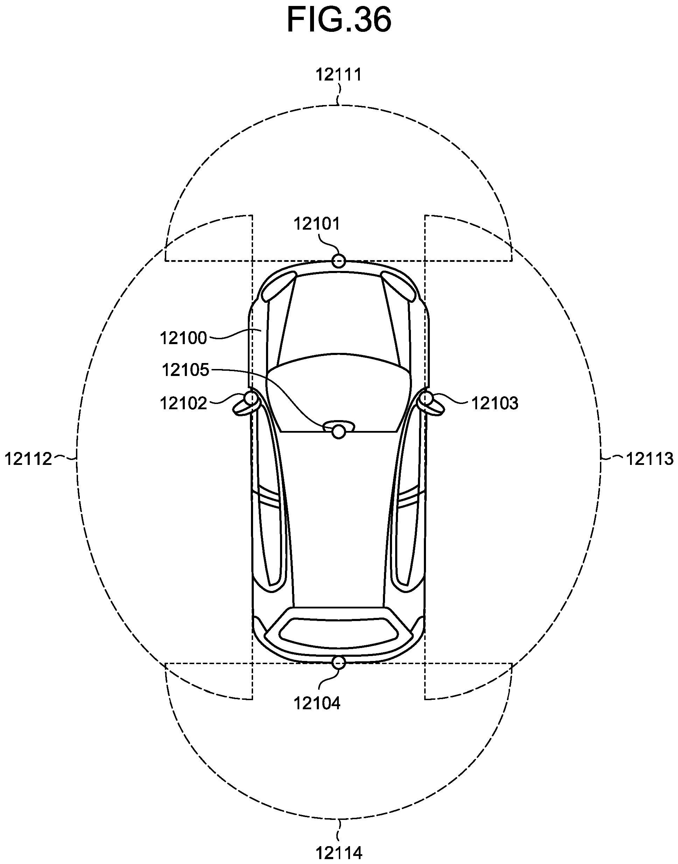

FIG. 36 is a diagram depicting an example of the installation position of the imaging section 12031.

In FIG. 36, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of a vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 36 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the imaging section 12031 among the configurations described above. Specifically, the imaging element 1 in FIG. 1 can be applied to the imaging section 12031. By applying the technology according to the present disclosure to the imaging section 12031, the imaging section 12031 can be downsized.

### (11. Applied Example to Endoscopic Surgery System)

The technology according to the present disclosure (present technology) can be applied to various products. For example, the technology according to the present disclosure may be applied to an endoscopic surgery system.

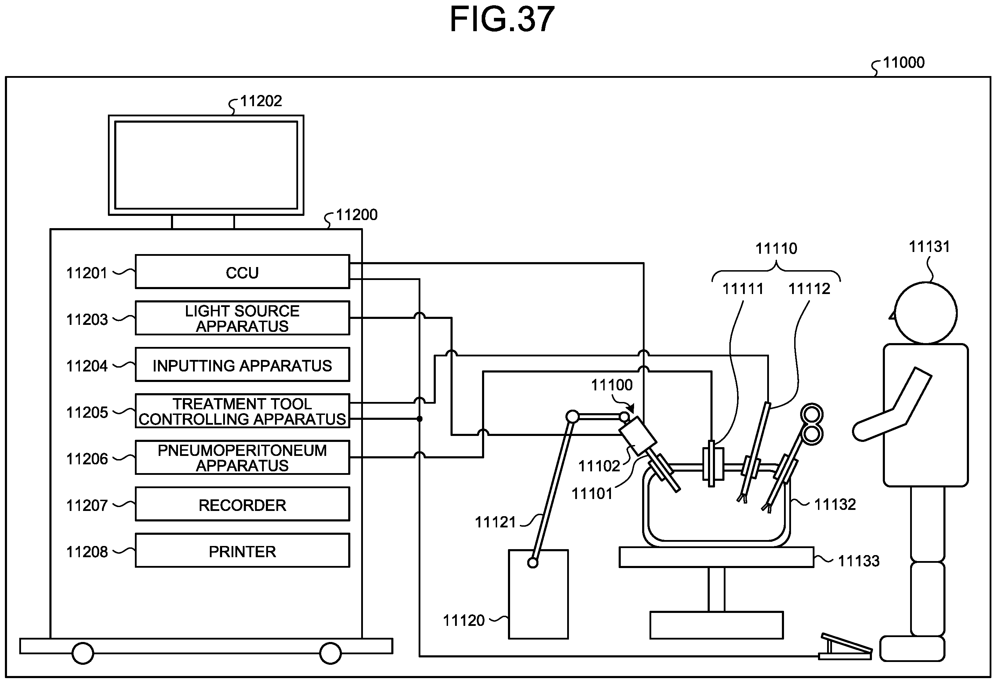

FIG. 37 is a view depicting an example of a schematic configuration of an endoscopic surgery system to which the technology according to an embodiment of the present disclosure (present technology) can be applied.

In FIG. 37, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

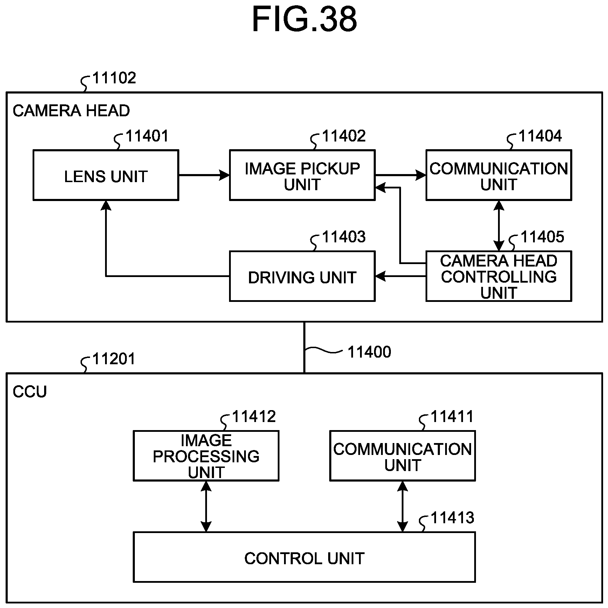

FIG. 38 is a block diagram depicting an example of a functional configuration of the camera head 11102 and the CCU 11201 depicted in FIG. 37.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure can be applied has been described above. The technology according to the present disclosure can be applied to the endoscope 11100 and the image pickup unit 11402 of the camera head 11102 among the above-described configurations. Specifically, the imaging element 1 in FIG. 1 can be applied to the image pickup unit 11402. By applying the technology according to the present disclosure to the image pickup unit 11402, the image pickup unit 11402 can be downsized.

Note that, here, the endoscopic surgery system has been described as an example, but the technology according to the present disclosure may be applied to, for example, a microscopic surgery system or the like.

Note that the technology of increasing the wiring capacitance by arranging the via plugs (for example, the via plugs 154 and 164) in the wirings (for example, the charge holding section wiring 155 and the capacitive coupling wiring 161) of the fifth and sixth embodiments of the present disclosure can also be applied to a semiconductor element other than the imaging element 1. For example, the technology of the fifth and sixth embodiments of the present disclosure can be applied to wiring constituting a capacitive element of a semiconductor element, wiring that performs boosting by capacitive coupling, and the like.

Note that the technology of increasing the wiring capacitance by arranging the second insulating layer (for example, the second insulating layer 282) having a higher dielectric constant than the insulating layer (for example, the insulating layer 251) in the wiring region (for example, the wiring region 250) according to the seventh and eighth embodiments of the present disclosure can also be applied to a semiconductor element other than the imaging element 1. For example, the technologies of the seventh and eighth embodiments of the present disclosure can be applied to wiring constituting a capacitive element of a semiconductor element, wiring that performs boosting by capacitive coupling, and the like.

Note that the effects described in the present specification are merely examples and are not limited, and other effects may be provided.

Note that the present technology can also have the following configurations.
(1) An imaging element comprising:
   a plurality of photoelectric conversion sections that performs photoelectric conversion of incident light to generate a charge;
   a charge holding section that holds the charge generated;
   a plurality of charge transfer sections that is arranged for each of the photoelectric conversion sections and transfers the charge generated to the charge holding section;
   an image signal generation section that generates an image signal according to the charge held; and
   a plurality of capacitive coupling wirings that is capacitively coupled to the charge holding section and to which an adjustment signal for adjusting a potential of the charge holding section is individually applied.
(2) The imaging element according to the above (1), further comprising:
   an auxiliary charge holding section that holds the charge generated; and
   a coupling section that couples the charge holding section and the auxiliary charge holding section.
(3) The imaging element according to the above (2), wherein at least one of the plurality of capacitive coupling wirings is capacitively coupled to the auxiliary charge holding section.
(4) The imaging element according to the above (2) or (3), further comprising:
   a plurality of pixel blocks including the plurality of photoelectric conversion sections, the plurality of charge transfer sections, the auxiliary charge holding section, the coupling section, and the image signal generation section; and
   an auxiliary charge holding section wiring that commonly connects the auxiliary charge holding section of each of the plurality of pixel blocks, wherein
   the plurality of capacitive coupling wirings is arranged in each of the plurality of pixel blocks.
(5) The imaging element according to the above (4), wherein the capacitive coupling wiring is capacitively coupled to the charge holding section and the auxiliary charge holding section.
(6) The imaging element according to the above (4) or (5), further comprising the capacitive coupling wiring that is capacitively coupled to the auxiliary charge holding section wiring.
(7) The imaging element according to any one of the above (1) to (6), further comprising
   a charge holding section wiring that connects the charge holding section and the image signal generation section, wherein
   the capacitive coupling wiring is capacitively coupled to the charge holding section wiring.
(8) The imaging element according to the above (7), wherein the capacitive coupling wiring is configured in a shape surrounding the charge holding section wiring.
(9) The imaging element according to the above (7) or (8), further comprising
   a plurality of charge transfer section signal wirings that respectively transmits control signals to the plurality of charge transfer sections, wherein
   the capacitive coupling wiring is arranged between the charge holding section wiring and the plurality of charge transfer section signal wirings.
(10) The imaging element according to any one of the above (7) to (9), wherein
   the charge holding section wiring includes a plurality of wirings arranged in different layers and an interlayer connection section that connects the plurality of wirings,
   the capacitive coupling wiring includes a plurality of wirings arranged in different layers and an interlayer connection section that connects the plurality of wirings, and
   the interlayer connection section of the charge holding section wiring is capacitively coupled to the interlayer connection section of the capacitive coupling wiring.
(11) The imaging element according to the above (10), wherein
   the charge holding section wiring further includes a plurality of the interlayer connection sections arranged in a same layer, and
   the capacitive coupling wiring further includes a plurality of the interlayer connection sections arranged in a same layer.
(12) The imaging element according to the above (11), wherein at least one of the interlayer connection section of the charge holding section wiring or the interlayer connection section of the capacitive coupling wiring is configured in a band shape.
(13) The imaging element according to any one of the above (1) to (12), further comprising:
   a first semiconductor substrate on which the plurality of photoelectric conversion sections, the plurality of charge transfer sections, and the charge holding section are arranged;
   a second semiconductor substrate laminated on the first semiconductor substrate and on which the image signal generation section is arranged; and
   a charge holding section wiring connecting the charge holding section and the image signal generation section, wherein
   the capacitive coupling wiring is capacitively coupled to the charge holding section wiring.
(14) The imaging element according to the above (13), wherein
   a back surface of the second semiconductor substrate is laminated on a wiring region arranged on a front surface of the first semiconductor substrate,
   the charge holding section wiring includes a through-substrate connection section extending from the front surface of the first semiconductor substrate to a front surface of the second semiconductor substrate, and
   the capacitive coupling wiring is further capacitively coupled to the through-substrate connection section.
(15) The imaging element according to any one of the above (1) to (14), further comprising a control section that supplies an adjustment signal to the plurality of capacitive coupling wirings.
(16) The imaging element according to the above (15), wherein the control section selects the capacitive coupling wiring being supplied the adjustment signal according to the number of the photoelectric conversion sections in which charge is transferred to the charge holding section.
(17) The imaging element according to any one of the above (7) to (16), further comprising a wiring region including a plurality of wirings including the charge holding section wiring, a first insulating layer that insulates the plurality of wirings, and a second insulating layer that is arranged between the charge holding section wiring and another one of the wirings and has a higher dielectric constant than the first insulating layer.
(18) The imaging element according to the above (17), wherein the second insulating layer is arranged between the charge holding section wiring and the capacitive coupling wiring that is the another one of the wirings.
(19) The imaging element according to the above (17), further comprising
   a plurality of charge transfer section signal wirings that is arranged in the wiring region and respectively transmits control signals to the plurality of charge transfer sections, wherein
   the second insulating layer is arranged between the charge holding section wiring and at least one of the plurality of capacitive coupling wirings which is the another one of the wirings.
(20) The imaging element according to any one of the above (4) to (19), further comprising a wiring region including a plurality of wirings including the auxiliary charge holding section wiring, a first insulating layer that insulates the plurality of wirings, and a second insulating layer that is arranged in a vicinity of the auxiliary charge holding section wiring and has a higher dielectric constant than the first insulating layer.
(21) An imaging apparatus comprising:
   a plurality of photoelectric conversion sections that performs photoelectric conversion of incident light to generate a charge;
   a charge holding section that holds the charge generated;
   a plurality of charge transfer sections that is arranged for each of the photoelectric conversion sections and transfers the charge generated to the charge holding section;
   an image signal generation section that generates an image signal according to the charge held;
   a plurality of capacitive coupling wirings that is capacitively coupled to the charge holding section and to which an adjustment signal for adjusting a potential of the charge holding section is individually applied; and
   a processing circuit that processes the image signal.
(22) A semiconductor element comprising:
   a semiconductor substrate; and
   a wiring region including a plurality of wirings arranged adjacent to the semiconductor substrate and including a first wiring and a second wiring, a first insulating layer that insulates the plurality of wirings, and a second insulating layer that is arranged between the first wiring and the second wiring and has a higher dielectric constant than the first insulating layer.
(23) The semiconductor element according to the above (22), further comprising
   a diffusion prevention film arranged between the first wiring and the second wiring, and the first insulating layer, wherein
   the second insulating layer is constituted by a same member as the diffusion prevention film.
(24) The semiconductor element according to the above (22) or (23), wherein a bottom section of the second insulating layer is configured in a shape deeper than the first wiring and the second wiring.
(25) The semiconductor element according to any one of the above (22) to (24), wherein the second insulating layer is configured in a shape having a side surface separated from the first wiring and the second wiring.
(26) The semiconductor element according to any one of the above (22) to (25), wherein
   the plurality of wirings and the first insulating layer are formed in multiple layers, and
   the second insulating layer is arranged in a plurality of layers.
(27) The semiconductor element according to the above (26), further comprising
   an interlayer connection section that connects wirings arranged in different layers, wherein
   the second insulating layer is arranged between the interlayer connection sections arranged on the first wiring and the second wiring.
(28) The semiconductor element according to any one of the above (22) to (27), further comprising a third insulating layer having a dielectric constant lower than the first insulating layer.

### Reference Signs List

1 IMAGING ELEMENT
10 PIXEL ARRAY SECTION
20 VERTICAL DRIVE SECTION
30 COLUMN SIGNAL PROCESSING SECTION
100, 100a, 100b, 100c, 100d PIXEL BLOCK
101a, 101b, 101c, 101d, 101e, 101f, 101g, 101h PHOTOELECTRIC CONVERSION SECTION
102, 102a, 102b, 102c, 102d, 102e, 102f, 102g, 102h CHARGE TRANSFER SECTION
105, 105' COUPLING SECTION
106 CHARGE HOLDING SECTION
107 AUXILIARY CHARGE HOLDING SECTION
110, 110a, 110b, 110c, 10d, 110e, 110f, 110g, 110h PIXEL
120 IMAGE SIGNAL GENERATION SECTION
130, 230 SEMICONDUCTOR SUBSTRATE
150, 151 WIRING REGION
151, 251 INSULATING LAYER
152, 156, 158, 166, 167, 252, 254, 257, 258, 265, 268, 272, 289, 290, 291 WIRING
280, 283 FIRST WIRING
281, 284 SECOND WIRING
153, 253 CONTACT PLUG
154, 157, 164, 165, 255, 256, 259, 264, 267, 269, 286, 287 VIA PLUG
155, 260 CHARGE HOLDING SECTION WIRING
161, 162, 169, 261, 262, 266, 271 CAPACITIVE COUPLING WIRING
275, 276, 277, 282, 285, 288 SECOND INSULATING LAYER
163, 263 AUXILIARY CHARGE HOLDING SECTION WIRING
274 DIFFUSION PREVENTION FILM
292 THIRD INSULATING LAYER
11402, 12031, 12101 to 12105 IMAGE PICKUP UNIT, IMAGING SECTION

## Claims

1. An imaging element comprising:
a plurality of photoelectric conversion sections that performs photoelectric conversion of incident light to generate a charge;
a charge holding section that holds the charge generated;
a plurality of charge transfer sections that is arranged for each of the photoelectric conversion sections and transfers the charge generated to the charge holding section;
an image signal generation section that generates an image signal according to the charge held; and
a plurality of capacitive coupling wirings that is capacitively coupled to the charge holding section and to which an adjustment signal for adjusting a potential of the charge holding section is individually applied.

2. The imaging element according to claim 1, further comprising:
an auxiliary charge holding section that holds the charge generated; and
a coupling section that couples the charge holding section and the auxiliary charge holding section.

3. The imaging element according to claim 2, wherein at least one of the plurality of capacitive coupling wirings is capacitively coupled to the auxiliary charge holding section.

4. The imaging element according to claim 2, further comprising:
a plurality of pixel blocks including the plurality of photoelectric conversion sections, the plurality of charge transfer sections, the auxiliary charge holding section, the coupling section, and the image signal generation section; and
an auxiliary charge holding section wiring that commonly connects the auxiliary charge holding section of each of the plurality of pixel blocks, wherein
the plurality of capacitive coupling wirings is arranged in each of the plurality of pixel blocks.

5. The imaging element according to claim 4, wherein the capacitive coupling wiring is capacitively coupled to the charge holding section and the auxiliary charge holding section.

6. The imaging element according to claim 4, further comprising the capacitive coupling wiring that is capacitively coupled to the auxiliary charge holding section wiring.

7. The imaging element according to claim 1, further comprising
a charge holding section wiring that connects the charge holding section and the image signal generation section, wherein
the capacitive coupling wiring is capacitively coupled to the charge holding section wiring.

8. The imaging element according to claim 7, wherein the capacitive coupling wiring is configured in a shape surrounding the charge holding section wiring.

9. The imaging element according to claim 7, further comprising
a plurality of charge transfer section signal wirings that respectively transmits control signals to the plurality of charge transfer sections, wherein
the capacitive coupling wiring is arranged between the charge holding section wiring and the plurality of charge transfer section signal wirings.

10. The imaging element according to claim 7, wherein
the charge holding section wiring includes a plurality of wirings arranged in different layers and an interlayer connection section that connects the plurality of wirings,
the capacitive coupling wiring includes a plurality of wirings arranged in different layers and an interlayer connection section that connects the plurality of wirings, and
the interlayer connection section of the charge holding section wiring is capacitively coupled to the interlayer connection section of the capacitive coupling wiring.

11. The imaging element according to claim 10, wherein
the charge holding section wiring further includes a plurality of the interlayer connection sections arranged in a same layer, and
the capacitive coupling wiring further includes a plurality of the interlayer connection sections arranged in a same layer.

12. The imaging element according to claim 11, wherein at least one of the interlayer connection section of the charge holding section wiring or the interlayer connection section of the capacitive coupling wiring is configured in a band shape.

13. The imaging element according to claim 1, further comprising:
a first semiconductor substrate on which the plurality of photoelectric conversion sections, the plurality of charge transfer sections, and the charge holding section are arranged;
a second semiconductor substrate laminated on the first semiconductor substrate and on which the image signal generation section is arranged; and
a charge holding section wiring connecting the charge holding section and the image signal generation section, wherein
the capacitive coupling wiring is capacitively coupled to the charge holding section wiring.

14. The imaging element according to claim 13, wherein
a back surface of the second semiconductor substrate is laminated on a wiring region arranged on a front surface of the first semiconductor substrate,
the charge holding section wiring includes a through-substrate connection section extending from the front surface of the first semiconductor substrate to a front surface of the second semiconductor substrate, and
the capacitive coupling wiring is further capacitively coupled to the through-substrate connection section.

15. The imaging element according to claim 1, further comprising a control section that supplies an adjustment signal to the plurality of capacitive coupling wirings.

16. The imaging element according to claim 15, wherein the control section selects the capacitive coupling wiring being supplied the adjustment signal according to the number of the photoelectric conversion sections in which charge is transferred to the charge holding section.

17. The imaging element according to claim 7, further comprising a wiring region including a plurality of wirings including the charge holding section wiring, a first insulating layer that insulates the plurality of wirings, and a second insulating layer that is arranged between the charge holding section wiring and another one of the wirings and has a higher dielectric constant than the first insulating layer.

18. The imaging element according to claim 17, wherein the second insulating layer is arranged between the charge holding section wiring and the capacitive coupling wiring that is the another one of the wirings.

19. The imaging element according to claim 17, further comprising
a plurality of charge transfer section signal wirings that is arranged in the wiring region and respectively transmits control signals to the plurality of charge transfer sections, wherein
the second insulating layer is arranged between the charge holding section wiring and at least one of the plurality of capacitive coupling wirings which is the another one of the wirings.

20. The imaging element according to claim 4, further comprising a wiring region including a plurality of wirings including the auxiliary charge holding section wiring, a first insulating layer that insulates the plurality of wirings, and a second insulating layer that is arranged in a vicinity of the auxiliary charge holding section wiring and has a higher dielectric constant than the first insulating layer.

21. An imaging apparatus comprising:
a plurality of photoelectric conversion sections that performs photoelectric conversion of incident light to generate a charge;
a charge holding section that holds the charge generated;
a plurality of charge transfer sections that is arranged for each of the photoelectric conversion sections and transfers the charge generated to the charge holding section;
an image signal generation section that generates an image signal according to the charge held;
a plurality of capacitive coupling wirings that is capacitively coupled to the charge holding section and to which an adjustment signal for adjusting a potential of the charge holding section is individually applied; and
a processing circuit that processes the image signal.

22. A semiconductor element comprising:
a semiconductor substrate; and
a wiring region including a plurality of wirings arranged adjacent to the semiconductor substrate and including a first wiring and a second wiring, a first insulating layer that insulates the plurality of wirings, and a second insulating layer that is arranged between the first wiring and the second wiring and has a higher dielectric constant than the first insulating layer.

23. The semiconductor element according to claim 22, further comprising
a diffusion prevention film arranged between the first wiring and the second wiring, and the first insulating layer, wherein
the second insulating layer is constituted by a same member as the diffusion prevention film.

24. The semiconductor element according to claim 22, wherein a bottom section of the second insulating layer is configured in a shape deeper than the first wiring and the second wiring.

25. The semiconductor element according to claim 22, wherein the second insulating layer is configured in a shape having a side surface separated from the first wiring and the second wiring.

26. The semiconductor element according to claim 22, wherein
the plurality of wirings and the first insulating layer are formed in multiple layers, and
the second insulating layer is arranged in a plurality of layers.

27. The semiconductor element according to claim 26, further comprising
an interlayer connection section that connects wirings arranged in different layers, wherein
the second insulating layer is arranged between the interlayer connection sections arranged on the first wiring and the second wiring.

28. The semiconductor element according to claim 22, further comprising a third insulating layer having a dielectric constant lower than the first insulating layer.
